# EUROPEAN PATENT APPLICATION

(11) **EP 4 723 852 A1**
(43) Date of publication of application: **08.04.2026**
(21) Application number: 24815740.6
(22) Date of filing: 13.05.2024
(51) Int. Cl.: H10K 59/131, H10K 59/80, H01L 27/02, G09G 3/3208, H01L 29/786, H01L 27/12

(54) **DISPLAY APPARATUS**

(30) Priority: 26.05.2023 KR 20230068626; 30.06.2023 KR 20230085336
(71) Applicant: Samsung Display Co., Ltd., Yongin-si, Gyeonggi-do 17113 (KR)
(72) Inventor: KIM, Dong Hyun, Yongin-si, Gyeonggi-do 17113 (KR); KANG, Chul Kyu, Yongin-si, Gyeonggi-do 17113 (KR); KIM, Su Jin, Yongin-si, Gyeonggi-do 17113 (KR); MOK, Seon Kyoon, Yongin-si, Gyeonggi-do 17113 (KR)
(74) Representative: Dr. Weitzel & Partner
(86) International application number: PCT/KR2024/006511
(87) International publication number: WO 2024/248362

(57) **Abstract**

This display device comprises: a substrate including a display area, and a peripheral area outside the display area; a plurality of data lines crossing the display area; a plurality of spider wires each electrically connected to corresponding data lines among the plurality of data lines and positioned in the peripheral area; and a plurality of protective circuits electrically connected to corresponding spider wires among the plurality of spider wires.

## Description

### Technical Field

Aspects of one or more embodiments of the present disclosure relate to a display apparatus, and more particularly, to a display apparatus capable of displaying high-quality images.

### Background Art

A display apparatus includes a display area. Display elements, such as organic light-emitting elements, are arranged in the display area. In addition, data lines are arranged in the display area. The data lines transfer data signals to the display elements.

### Disclosure of Invention

### Technical Problem

However, a display apparatus according to a comparative example may include a construction for preventing influences due to electrostatic discharge from the outside, so that high-quality images cannot be displayed.

### Solution to Problem

One or more embodiments of the present disclosure are directed to a display apparatus capable of displaying high-quality images. However, the aspects and features of the present disclosure are not limited thereto.

According to one or more embodiments of the present disclosure, a display apparatus includes: a substrate including a display area, and a peripheral area outside the display area; a plurality of data lines crossing the display area; a plurality of spider lines in the peripheral area, each of the plurality of spider lines being electrically connected to a corresponding data line from among the plurality of data lines; and a plurality of protective circuits, each of the plurality of protective circuits being electrically connected to a corresponding spider line from among the plurality of spider lines.

In an embodiment, the plurality of data lines may correspond one-to-one to the plurality of spider lines.

In an embodiment, the plurality of spider lines may correspond one-to-one to the plurality of protective circuits.

In an embodiment, the plurality of protective circuits may be located between the plurality of spider lines.

In an embodiment, the display apparatus may further include: a plurality of power lines crossing the display area; and a power supply line in the peripheral area over the plurality of spider lines, the power supply line being electrically connected to the plurality of power lines.

In an embodiment, a protective transistor of each of the plurality of protective circuits may be electrically connected to the power supply line.

In an embodiment, one end of a protective semiconductor layer of each of the plurality of protective circuits may be electrically connected to the power supply line, and another end of the protective semiconductor layer may be electrically connected to the corresponding spider line through a bridge line.

In an embodiment, the power supply line may include a plurality of through holes corresponding to the plurality of protective circuits, and in a plan view, the bridge line may be located inside a corresponding through hole from among the plurality of through holes.

In an embodiment, the bridge line and the power supply line may be at the same layer as each other.

In an embodiment, each of the plurality of spider lines may include a portion located at the same layer as that of a bottom conductive layer, the bottom conductive layer being located between the substrate and a first protective gate electrode of each of the plurality of protective circuits.

In an embodiment, each of the plurality of spider lines may include a portion located at the same layer as that of a first protective gate electrode of each of the plurality of protective circuits.

In an embodiment, each of the plurality of spider lines may include a first portion and a second portion. The first portion may be located at the same layer as that of a first protective gate electrode of each of the plurality of protective circuits, and the second portion may be located at the same layer as that of a bottom conductive layer located between the first protective gate electrode and the substrate. The first portion may be electrically connected to the second portion.

In an embodiment, each of the plurality of protective circuits may include a second protective gate electrode, and the second protective gate electrode may overlap with the first protective gate electrode, may be located at the same layer as that of the bottom conductive layer, and may be electrically connected to the first protective gate electrode.

In an embodiment, the display apparatus may further include: a common electrode covering the display area; and a common voltage line electrically connected to the common electrode, and located in the peripheral area over the plurality of spider lines.

In an embodiment, a protective transistor of each of the plurality of protective circuits may be electrically connected to the common voltage line.

In an embodiment, one end of a protective semiconductor layer of each of the plurality of protective circuits may be electrically connected to the common voltage line, and another end of the protective semiconductor layer may be electrically connected to the corresponding spider line through a bridge line.

In an embodiment, the common voltage line may include a plurality of through holes corresponding to the plurality of protective circuits, and in a plan view, the bridge line may be located inside a corresponding through hole from among the plurality of through holes.

In an embodiment, the bridge line and the common voltage line may be located at the same layer as each other.

In an embodiment, each of the plurality of spider lines may include a portion located at the same layer as that of a bottom conductive layer located between the substrate and a first protective gate electrode of each of the plurality of protective circuits.

In an embodiment, each of the plurality of spider lines may include a portion located at the same layer as that of a first protective gate electrode of each of the plurality of protective circuits.

In an embodiment, each of the plurality of spider lines may include a first portion and a second portion. The first portion may be located at the same layer as that of a first protective gate electrode of each of the plurality of protective circuits, and the second portion may be located at the same layer as that of a bottom conductive layer located between the first protective gate electrode and the substrate. The first portion may be electrically connected to the second portion.

In an embodiment, each of the plurality of protective circuits may include a second protective gate electrode, and the second protective gate electrode may overlap with the first protective gate electrode, may be located at the same layer as that of the bottom conductive layer, and may be electrically connected to the first protective gate electrode.

According to one or more embodiments of the present disclosure, a display apparatus includes: a substrate including a display area, and a peripheral area outside the display area; a plurality of pads located along one edge of the substrate in the peripheral area; and a plurality of protective circuits in the peripheral area between the display area and the plurality of pads.

The above and other aspects and features of the present disclosure will become more apparent and readily appreciated from the detailed description below with reference to the accompanying drawings.

### Advantageous Effects of Invention

According to one or more embodiments of the present disclosure described above, a display apparatus may be implemented that may display high-quality images. However, the aspects and features of the present disclosure are not limited thereto.

### Brief Description of Drawings

FIG. 1 is a schematic plan view of a portion of a display apparatus according to an embodiment.
FIG. 2 is a circuit diagram of a pixel circuit of a pixel included in the display apparatus of FIG. 1.
FIG. 3 is a timing diagram of control signals used to operate the pixel circuit shown in FIG. 2.
FIG. 4 is a schematic layout view of a pixel included in the display apparatus of FIG. 1.
FIGS. 5 to 9 are schematic plan views of various layers included in the layout view of FIG. 4.
FIG. 10 is a schematic cross-sectional view of the display apparatus taken along the lines B-B' of FIGS. 4 through 9.
FIG. 11 is a circuit diagram of an electrostatic discharge protective circuit included in the display apparatus of FIG. 1.
FIG. 12 is a schematic layout view of the region A of FIG. 1.
FIG. 13 is a schematic cross-sectional view of the display apparatus taken along the line C-C' of FIG. 12.
FIG. 14 is a schematic cross-sectional view of a portion of a display apparatus according to an embodiment.
FIG. 15 is a schematic layout view of a portion of a display apparatus according to an embodiment.
FIG. 16 is a schematic layout view of a portion of a display apparatus according to an embodiment.
FIG. 17 is a schematic layout view of a portion of a display apparatus according to an embodiment.
FIG. 18 is a schematic cross-sectional view of the display apparatus taken along the line D-D' of FIG. 17.
FIG. 19 is a schematic cross-sectional view of a portion of a display apparatus according to an embodiment.
FIG. 20 is a schematic layout view of a portion of a display apparatus according to an embodiment.
FIG. 21 is a schematic layout view of a portion of a display apparatus according to an embodiment.

### Best Mode for Carrying out the Invention

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

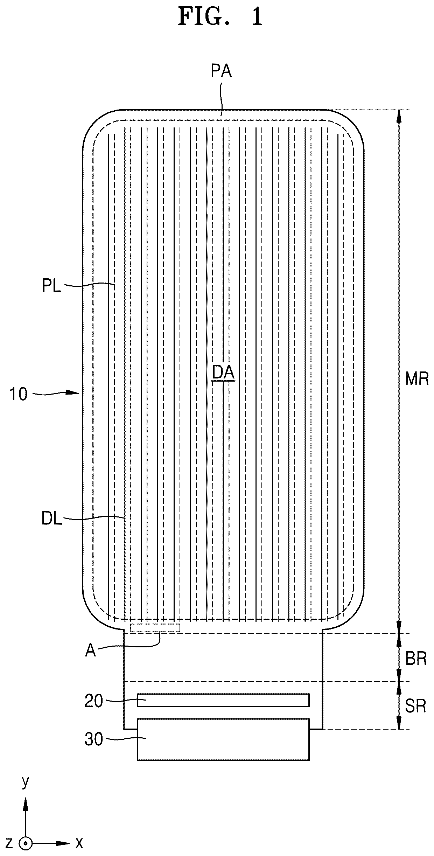

FIG. 1 is a schematic plan view of a portion of a display apparatus according to an embodiment.

Referring to FIG. 1, the display apparatus according to an embodiment includes a display panel 10. The display apparatus including the display panel 10 may be implemented in various suitable forms. For example, the display apparatus may include or be implemented as various suitable products, such as smartphones, tablet computers, laptop computers, televisions, advertisement boards, instrument panels for vehicles (e.g., automobiles), and/or the like.

The display panel 10 includes a display area DA, and a peripheral area PA outside the display area DA. The display area DA is a portion configured to display images, and a plurality of pixels may be arranged in the display area DA. When viewed in a direction perpendicular to or approximately perpendicular to the display panel 10 (e.g., in a plan view), the display area DA may have various suitable shapes, such as a circular shape, an elliptical shape, a polygonal shape, and/or a shape of a specific figure. FIG. 1 shows that the display area DA has an approximately rectangular shape having rounded corners as a representative example.

The peripheral area PA may be arranged outside the display area DA. The width (e.g., in the x axis direction) of a portion of the peripheral area PA may be less than the width (e.g., in the x axis direction) of the display area DA. Through this structure, at least a portion of the peripheral area PA may be bent (e.g., easily bent) as needed or desired.

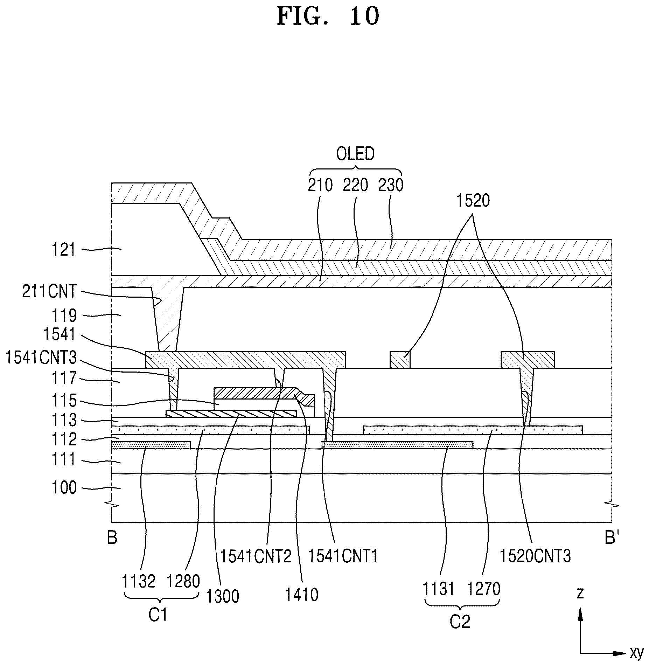

Because the display panel 10 includes a substrate 100 (e.g., see FIG. 10), the substrate 100 may be considered as including the display area DA and the peripheral area PA. Hereinafter, for convenience, the substrate 100 that includes the display area DA and the peripheral area PA may be assumed.

A plurality of data lines DL may be arranged in the display area DA to cross the display area DA. Similarly, a plurality of power lines PL may be arranged in the display area DA to cross the display area DA. For convenience of illustration, FIG. 1 shows that the data lines DL are indicated by solid lines and the power lines PL are indicated by dashed lines. The data lines DL and the power lines PL may be formed concurrently or substantially simultaneously with each other at (e.g., in or on) the same layer as each other, and may include the same material as each other.

In some embodiments, the display panel 10 may include a main region MR, a bending region BR outside the main region MR, and a sub-region SR arranged opposite to the main region MR with the bending region BR therebetween. Because bending of the display panel 10 is performed in the bending region BR, when viewed in the z axis direction (e.g., in a plan view), at least a portion of the sub-region SR may overlap with the main region MR. However, the present disclosure is not limited to a display apparatus that is bent, and embodiments described herein may include or may be applicable to a display apparatus that is not bent. The sub-region SR may be a non-display area. Because the display panel 10 is bent in the bending region BR, when the display apparatus is viewed from the front surface thereof (e.g., in the -z-axis direction), the non-display area may not be viewed, or an area of the non-display area that can be viewed may be reduced.

A driving chip 20 and the like may be arranged in the sub-region SR of the display panel 10. The driving chip 20 may include an integrated circuit configured to drive the display panel 10. The integrated circuit may be a data driving integrated circuit configured to generate data signals, but the present disclosure is not limited thereto.

The driving chip 20 may be arranged in the sub-region SR of the display panel 10. The driving chip 20 may be disposed over the same surface as that of a display surface of the display area DA, but as described above, because the display panel 10 may be bent in the bending region BR, the driving chip 20 may be disposed over the rear surface of the main region MR.

A printed circuit board 30 and/or the like may be attached to an edge of the sub-region SR of the display panel 10. The printed circuit board 30 and/or the like may be electrically connected to the driving chip 20 and the like through a plurality of pads arranged along one edge of the substrate.

Hereinafter, an organic light-emitting display apparatus may be described in more detail as an example of the display apparatus according to an embodiment, but the present disclosure is not limited thereto. In another embodiment, the display apparatus may be an inorganic light-emitting display apparatus or a quantum-dot light-emitting display apparatus. As an example, an emission layer of a display element of the display apparatus may include an organic material or an inorganic material. In addition, the display apparatus may include an emission layer, and a quantum-dot layer on a path of light emitted from the emission layer.

The display panel 10 includes the substrate 100. Various elements of the display panel 10 may be disposed over the substrate 100. The substrate 100 may include glass, a metal, or a polymer resin. In the case where the display panel 10 is bent in the bending region BR as described above, the substrate 100 may be flexible or bendable. In this case, the substrate 100 may include a polymer resin, such as polyethersulphone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two or more layers, each including the polymer resin, and a barrier layer including an inorganic material (such as silicon oxide, silicon nitride, and/or silicon oxynitride) therebetween. However, the present disclosure is not limited thereto, and various modifications may be made.

A plurality of pixels are arranged in the display area DA. Each of the pixels may denote a sub-pixel, and may include a display element, such as an organic light-emitting diode OLED. The pixel may be configured to emit, for example, red, green, blue, or white light.

The pixel may be electrically connected to outer circuits arranged in the peripheral area PA. A scan driving circuit, an emission control driving circuit, a pad, a power supply line, a common voltage line, and the like may be arranged in the peripheral area PA. The scan driving circuit may be configured to provide scan signals to the pixel through a scan line. The emission control driving circuit may be configured to provide emission control signals to the pixel through an emission control line. A pad arranged in the peripheral area PA of the substrate 100 may be exposed and electrically connected to the printed circuit board 30 by not being covered by an insulating layer. A terminal of the printed circuit board 30 may be electrically connected to the pad of the display panel 10.

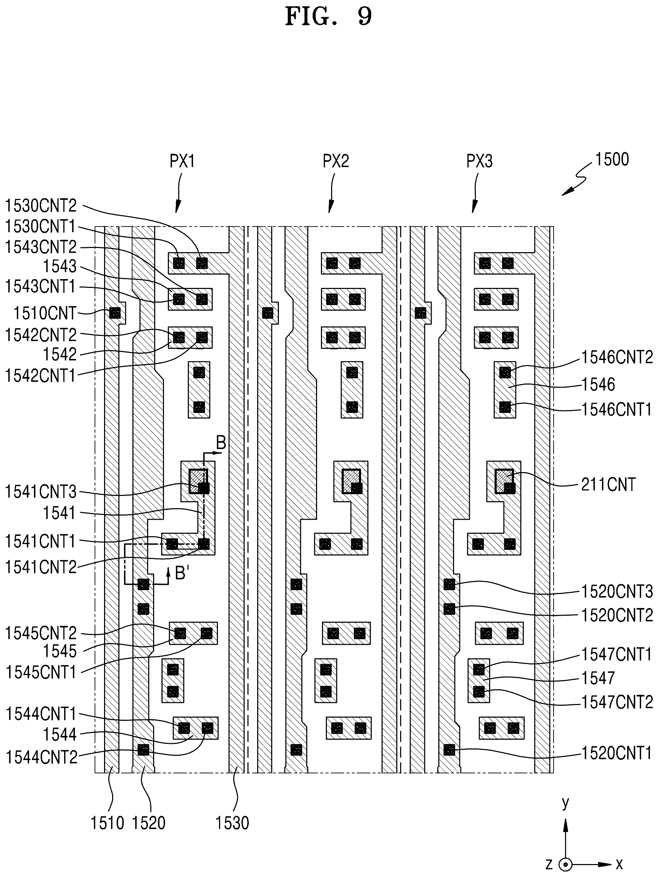

The printed circuit board 30 is configured to transfer signals of a controller or power to the display panel 10. Control signals generated by the controller may be respectively transferred to the driving circuits through the printed circuit board 30. In addition, the controller may be configured to transfer a first power voltage to the power supply line, and may provide a second power voltage to the common voltage line. A first power voltage ELVDD (e.g., a driving voltage) may be transferred to each pixel through the power line PL (e.g., see 1520 in FIG. 9) connected to the power supply line, and a second power voltage ELVSS (e.g., a common voltage) may be transferred to a common electrode 230 (e.g., see FIG. 10) of a pixel connected to the common voltage line. Because the common voltage line has a loop shape having one open side, where the driving chip 20 and the like may be arranged, the common voltage line may have a shape partially surrounding (e.g., around a periphery of) the display area DA.

The controller may be configured to generate data signals, and the generated data signals may be transferred to the pixel through the driving chip 20 and a data line DL (e.g., see 1510 in FIG. 9).

For reference, a "line" may refer to a "wiring". This is applicable to the embodiments described in more detail below and modifications thereof.

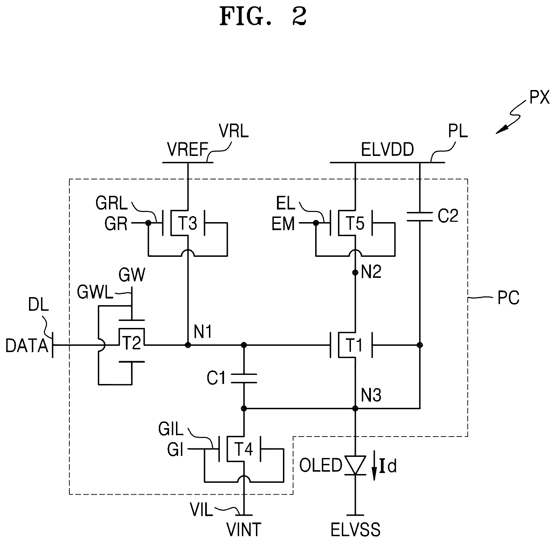

FIG. 2 is a circuit diagram of a pixel circuit of a pixel included in the display apparatus of FIG. 1. In other words, FIG. 2 is an equivalent circuit diagram of a pixel included in the display apparatus of FIG. 1.

Referring to FIG. 2, the pixel PX may include an organic light-emitting diode OLED as a display element, and a pixel circuit PC connected to the organic light-emitting diode OLED. The pixel circuit PC may include first to fifth transistors T1, T2, T3, T4, and T5, a first capacitor C1, and a second capacitor C2. The first transistor T1 may be a driving transistor in which the magnitude of a source-drain current is determined according to a potential difference between a gate electrode and a source region. The second to fifth transistors T2, T3, T4, and T5 may be switching transistors that are turned on or turned off according to a potential difference between a gate electrode thereof and a source region thereof, or in other words, a voltage or substantially a voltage applied to the gate electrode thereof. The first transistor to fifth transistors T1, T2, T3, T4, and T5 may each be implemented as a thin-film transistor. Depending on the kind (e.g., p-type or n-type) and/or an operation condition of a transistor, a first terminal of each of the first to fifth transistors T1, T2, T3, T4, and T5 may be a source region or a drain region, and a second terminal of each of the first to fifth transistors T1, T2, T3, T4, and T5 may be different from the first terminal. As an example, in the case where the first terminal is a source region, the second terminal may be a drain region.

The pixel PX may be connected to a first scan line GWL, a second scan line GIL, a third scan line GRL, an emission control line EL, and a data line DL. The first scan line GWL may transfer a first scan signal GW, the second scan line GIL may transfer a second scan signal GI, the third scan line GRL may transfer a third scan signal GR, the emission control line EL may transfer an emission control signal EM, and the data line DL may transfer a data signal DATA. The power line PL may be configured to transfer the first power voltage ELVDD (e.g., the driving voltage) to the first transistor T1. An initialization voltage line VIL may transfer an initialization voltage VINT to the organic light-emitting diode OLED. A reference voltage line VRL may be configured to transfer a reference voltage VREF to the gate electrode of the first transistor T1.

Semiconductor layers of the first to fifth transistors T1, T2, T3, T4, and T5 may include an oxide semiconductor. Because the oxide semiconductor may have high carrier mobility and a low leakage current, a voltage drop may not be large even when a driving time is long. In other words, in the oxide semiconductor, because a color change of an image according to a voltage drop may not be large even while the display apparatus is driven in low frequencies, the display apparatus may be driven in low frequencies. Accordingly, due to the semiconductor layer of the first to fifth transistors T1, T2, T3, T4, and T5 including the oxide semiconductor, a display apparatus may be implemented in which the occurrence of a leakage current may be prevented or reduced, and at the same time, power consumption may be reduced. In addition, in the case where an oxide semiconductor transistor is used, because a crystallization process by excimer laser annealing may not be required to form a low-temperature polycrystalline silicon (LTPS), manufacturing costs of a display panel may be reduced (e.g., remarkably reduced). Accordingly, oxide semiconductor transistors may be used to realize larger-area display apparatuses.

Because an oxide semiconductor may be sensitive to light, fluctuation may occur in the amount of current due to external light. Accordingly, external light may be absorbed or reflected by disposing a metal layer under the oxide semiconductor. A metal layer disposed under the oxide semiconductor of each of the first to fifth transistors T1, T2, T3, T4, and T5 may serve as a lower gate electrode. In other words, each of the first to fifth transistors T1, T2, T3, T4, and T5 may be a double-gate transistor including two gate electrodes. The two gate electrodes may be disposed at (e.g., in or on) different layers from each other, and may overlap with each other. As an example, each of the first to fifth transistors T1, T2, T3, T4, and T5 may be an N-channel oxide semiconductor transistor, and the gate electrodes of each of the first to fifth transistors T1, T2, T3, T4, and T5 may be disposed to face each other with an oxide semiconductor therebetween.

The first transistor T1 includes a first gate electrode connected to a first node N1, a second gate electrode connected to a third node N3, a first terminal connected to a second node N2, and a second terminal connected to the third node N3. The second gate electrode of the first transistor T1 may be connected to the second terminal of the first transistor T1, may be controlled by a voltage applied to the second terminal of the first transistor T1, and may be configured to improve an output saturation characteristic of the first transistor T1. The first terminal of the first transistor T1 may be connected to the power line PL through the fifth transistor T5, and the second terminal of the first transistor T1 may be electrically connected to a pixel electrode of the organic light-emitting diode OLED. The first transistor T1 serves as the driving transistor, and receives a data signal DATA according to a switching operation of the second transistor T2 to control the amount of a driving current I_{d} flowing through the organic light-emitting diode OLED.

The second transistor T2, which may be a data-write transistor, includes a first gate electrode and a second gate electrode, each connected to the first scan line GWL, a first terminal connected to the data line DL, and a second terminal connected to the first node N1. The second terminal of the second transistor T2 may be electrically connected to the gate electrode of the first transistor T1. The second transistor T2 may be turned on according to a first scan signal GW transferred from the first scan line GWL to electrically connect the data line DL to the first node N1, and transfer a data signal DATA from the data line DL to the first node N1.

The third transistor T3, which may be a first initialization transistor, includes a first gate electrode and a second gate electrode, each connected to the third scan line GRL, a first terminal connected to the reference voltage line VRL, and a second terminal connected to the first node N1. The second terminal of the third transistor T3 may be electrically connected to the gate electrode of the first transistor T1. The third transistor T3 may be turned on according to a third scan signal GR transferred from the third scan line GRL to transfer the reference voltage VREF from the reference voltage line VRL to the first node N1.

The fourth transistor T4, which may be a second initialization transistor, includes a first gate electrode and a second gate electrode, each connected to the second scan line GIL, a first terminal connected to the third node N3, and a second terminal connected to the initialization voltage line VIL. The first terminal of the fourth transistor T4 may be electrically connected to the second terminal of the first transistor T1. The fourth transistor T4 may be turned on according to a second scan signal GI transferred from the second scan line GIL to transfer the initialization voltage VINT from the initialization voltage line VIL to the third node N3.

The fifth transistor T5, which may be an emission control transistor, includes a first gate electrode and a second gate electrode, each connected to the emission control line EL, a first terminal connected to the power line PL, and a second terminal connected to the second node N2. The second terminal of the fifth transistor T5 may be electrically connected to the first terminal of the first transistor T1. The fifth transistor T5 may be turned on or turned off according to an emission control signal EM transferred from the emission control line EL.

The first capacitor C1, which may be a storage capacitor, may be electrically connected between the first node N1 and the third node N3. A first terminal of the first capacitor C1 may be connected to the gate electrode of the first transistor T1. A second terminal of the first capacitor C1 may be connected to the second gate electrode and the second terminal of the first transistor T1, the first terminal of the fourth transistor T4, and the pixel electrode of the organic light-emitting diode OLED. The first capacitor C1 serves as a storage capacitor, and is configured to store a threshold voltage of the first transistor T1 and a voltage corresponding to the data signal DATA.

The second capacitor C2, which may be a holding capacitor, may be electrically connected between the third node N3 and the power line PL. A first terminal of the second capacitor C2 may be connected to the power line PL. A second terminal of the second capacitor C2 may be connected to the second gate electrode and the second terminal of the first transistor T1, the second terminal of the first capacitor C1, the first terminal of the fourth transistor T4, and the pixel electrode of the organic light-emitting diode OLED. In some embodiments, the capacity of the first capacitor C1 may be greater than the capacity of the second capacitor C2.

The organic light-emitting diode OLED may include the pixel electrode (e.g., an anode), and the common electrode (e.g., a cathode) facing the pixel electrode. The common electrode may receive the second power voltage ELVSS (e.g., the common voltage). The common electrode may be integrally formed over a plurality of organic light-emitting diodes OLED.

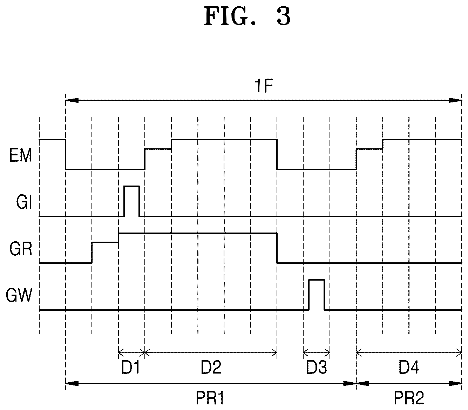

FIG. 3 is a timing diagram of control signals used to operate the pixel circuit shown in FIG. 2.

Referring to FIGS. 2 and 3 together, the pixel PX may operate in first to fourth periods D1, D2, D3, and D4 during one frame 1F. Hereinafter, for convenience, the first to third periods D1, D2, and D3 are referred to as a first non-emission period PR1 during which the pixel does not emit light, and the fourth period D4 is referred to as a first emission period PR2 during which the pixel emits light.

A second scan signal GI may be supplied as a turn-on voltage during the first period D1. A first scan signal GW may be supplied as a turn-on voltage during the third period D3. In other words, a period during which the second scan signal GI has a turn-on voltage may precede a period during which the first scan signal GW has a turn-on voltage. A third scan signal GR may be supplied as a turn-on voltage during the first period D1 and the second period D2. An emission control signal EM may be supplied as a turn-off voltage during the first period D1 and the third period D3, and may be supplied as a turn-on voltage during the second period D2 and the fourth period D4. A pulse width of the first scan signal GW, the second scan signal GI, and the third scan signal GR may be a turn-on voltage maintaining period. A pulse width of the emission control signal EM may be a period having a turn-off voltage. Here, the turn-on voltage may be the turn-on voltage of a transistor, and may be, for example, a high-level voltage depending on the kind of the transistor.

The first power voltage ELVDD (e.g., the driving voltage) may be supplied from the power line PL, the reference voltage VREF may be supplied from the reference voltage line VRL, and the initialization voltage VINT may be supplied from the initialization voltage line VIL.

The first period D1 may be an initialization period that initializes the first node N1 to which the gate electrode of the first transistor T1 is connected, and the third node N3 to which the pixel electrode (e.g., the anode) of the organic light-emitting diode OLED is connected.

During the first period D1, the second scan signal GI of a turn-on voltage may be supplied to the second scan line GIL, and the third scan signal GR of a turn-on voltage may be supplied to the third scan line GRL. The first scan signal GW and the emission control signal EM may be supplied as turn-off voltages. The turn-on voltage of the second scan signal GI may have a width of about 1 horizontal scanning period.

The fourth transistor T4 may be turned on by the second scan signal GI, and the third transistor T3 may be turned on by the third scan signal GR. The third transistor T3 may be turned on, and the reference voltage VREF may be supplied to the first node N1, or in other words, to the gate electrode of the first transistor T1. The fourth transistor T4 may be turned on, and the voltage of the third node N3, or in other words, the voltage of the pixel electrode of the organic light-emitting diode OLED, may be set to the initialization voltage VINT. In other words, the organic light emitting diode OLED may be initialized by discharging a parasitic capacitor formed in the organic light emitting diode (OLED).

The second period D2 may be a compensation period to compensate for a threshold voltage of the first transistor T1. During the second period D2, the first scan signal GW may maintain a turn-off voltage, the second scan signal GI may be changed to a turn-off voltage, the third scan signal GR may maintain a turn-on voltage, and the emission control signal EM may be changed to a turn-on voltage.

During the second period D2, the third scan signal GR of a turn-on voltage may be supplied to the third scan line GRL so the third transistor T3 may be turned on, and the emission control signal EM of a turn-on voltage may be supplied to the emission control line EL so the fifth transistor T5 may be turned on. Accordingly, the first power voltage ELVDD (e.g., the driving voltage) may be supplied to the second node N2, the reference voltage VREF may be supplied to the first node N1 so the first transistor T1 may be turned on, and when the voltage of the second terminal of the first transistor T1 is reduced below a difference between the reference voltage VREF and a threshold voltage Vₜₕ of the first transistor T1 (e.g., VREF-Vₜₕ), the first transistor T1 may be turned off. In addition, the first capacitor C1 may be charged with a voltage corresponding to the threshold voltage Vₜₕ of the first transistor T1.

The third period D3 may be a data-write period during which a data signal is supplied to the pixel. During the third period D3, the second scan signal GI may maintain a turn-off voltage, the third scan signal GR and the emission control signal EM may be changed to turn-off voltages, and the first scan signal GW may be changed to a turn-on voltage. The turn-on voltage of the first scan signal GW may have a width of 1 horizontal scanning period.

During the third period D3, the first scan signal GW of a turn-on voltage may be supplied to the first scan line GWL so the second transistor T2 may be turned on. In this case, the third transistor T3, the fourth transistor T4, and the fifth transistor T5 may be turned off by the second scan signal GI, the third scan signal GR, and the emission control signal EM of the turn-off voltages.

The second transistor T2 may be configured to transfer the data signal DATA from the data line DL to the first node N1, or in other words, to the gate electrode of the first transistor T1. Accordingly, the voltage of the first node N1 may be changed from the reference voltage VREF to a voltage corresponding to the data signal DATA. In this case, the voltage of the second node N2 may also be changed in response to the amount of voltage change of the first node N1. The voltage of the second node N2 may change according to a capacity ratio between the first capacitor C1, the second capacitor C2, and the parasitic capacitor of the organic light-emitting diode OLED. Accordingly, the first capacitor C1 may be charged with a voltage corresponding to the threshold voltage Vₜₕ of the first transistor T1 and the data signal DATA.

The fourth period D4 may be a period in which the organic light-emitting diode OLED emits light. During the fourth period D4, the emission control signal EM may be changed to a turn-on voltage, and the first scan signal GW, the second scan signal GI, and the third scan signal GR may be the turn-off voltages.

During the fourth period D4, the second transistor T2, the third transistor T3, and the fourth transistor T4 may be turned off by the first scan signal GW, the second scan signal GI, and the third scan signal GR of the turn-off voltages, the fifth transistor T5 may be turned on by the emission control signal EM of the turn-on voltage, and the first power voltage ELVDD (e.g., the driving voltage) may be supplied to the second node N2.

The first transistor T1 may be configured to output the driving current I_{d} (e.g., ∝ V_{GS}-Vₜₕ)²), and thus, the organic light-emitting diode OLED may emit light having a brightness corresponding to the driving current I_{d} regardless of the threshold voltage Vₜₕ of the first transistor T1. In this case, the driving current I_{d} may have a magnitude corresponding to a voltage stored in the first capacitor C1, or in other words, a voltage obtained by subtracting the threshold voltage Vₜₕ of the first transistor T1 from a potential difference V_{GS} (e.g., a potential difference between the first node N1 and the third node N3) between the gate electrode-source region of the first transistor T1 (e.g., V_{GS}-Vₜₕ).

The driving mode described above with reference to FIG. 3 is provided as an example, and the display apparatus according to another embodiment may operate in another suitable driving mode.

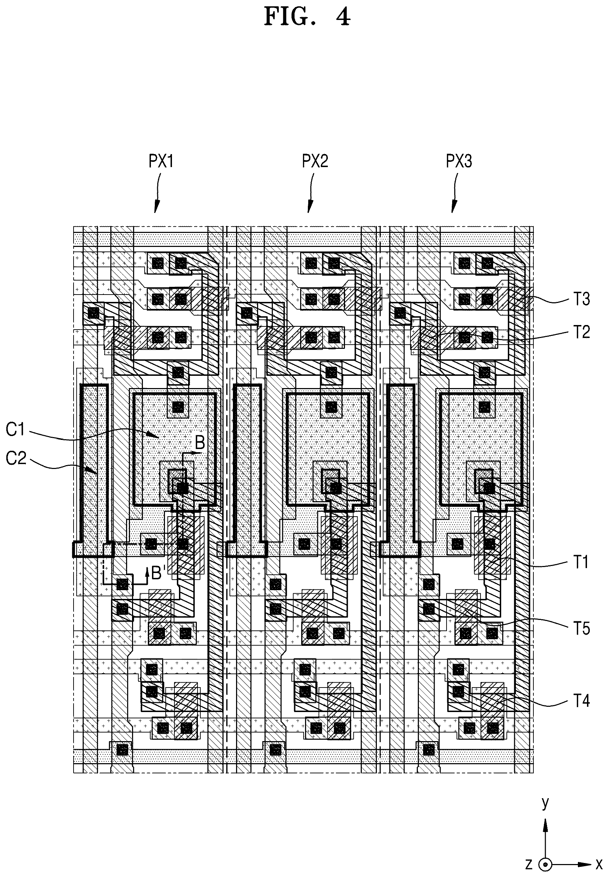

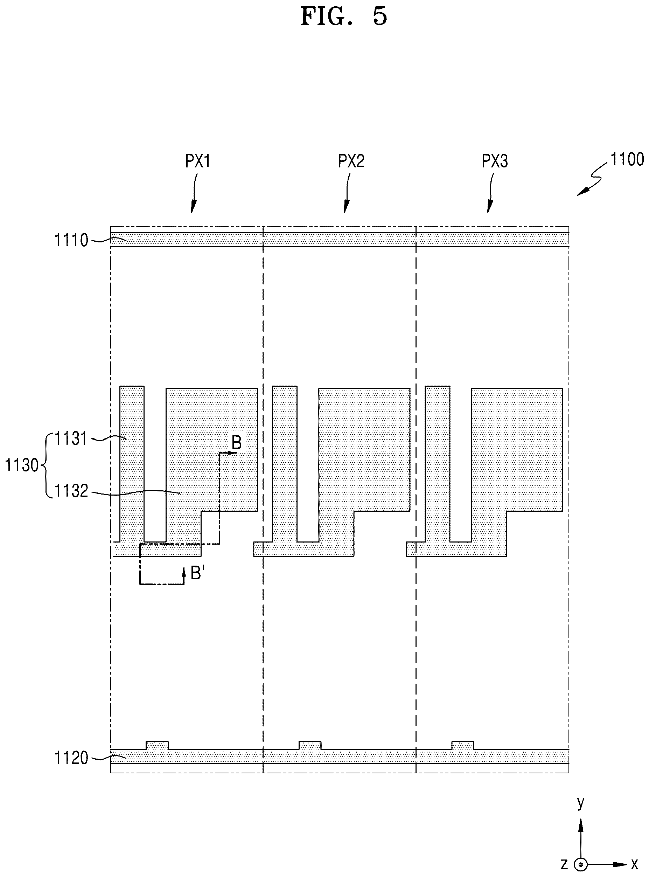

FIG. 4 is a schematic layout view of a pixel included in the display apparatus of FIG. 1. FIGS. 5 through 9 are schematic plan views of various layers included in the layout view of FIG. 4. FIG. 10 is a schematic cross-sectional view of the display apparatus taken along the lines B-B' of FIGS. 4 through 9.

Referring to FIGS. 4 through 9, the display apparatus may include a first pixel PX1, a second pixel PX2, and a third pixel PX3 that are adjacent to each other. The first to third pixels PX1, PX2, and PX3 may have the same or substantially the same shape as that shown in FIG. 4 and the like. However, the present disclosure is not limited thereto, and the first to third pixels PX1, PX2, and PX3 may have various different configurations.

The first to third pixels PX1, PX2, and PX3 may each include the same or substantially the same (or similar) pixel circuit structure as each other. Hereinafter, for convenience, some conductive patterns are described in more detail based on the configuration of the first pixel PX1, but the conductive patterns may be applicable to the second pixel PX2 and the third pixel PX3, and thus, redundant description may not be repeated.

A first buffer layer 111 may be disposed on the substrate 100. The first buffer layer 111 may include silicon oxide, silicon nitride, or silicon oxynitride. The first buffer layer 111 may be configured to prevent or substantially prevent metal atoms, impurities, and/or the like from diffusing from substrate 100 to the elements disposed thereon.

A first bottom conductive layer 1100 shown in FIG. 5 may be disposed on the first buffer layer 111. The first bottom conductive layer 1100 may include a metal, an alloy, a conductive metal oxide, a transparent conductive material, and/or the like. As an example, the first bottom conductive layer 1100 may include silver (Ag), an alloy containing silver, molybdenum (Mo), an alloy containing molybdenum, aluminum (Al), an alloy containing aluminum, aluminum nitride (AIN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. The first bottom conductive layer 1100 may have a multi-layered structure. As an example, the first bottom conductive layer 1100 may have a two-layered structure of Mo/Al, or a three-layered structure of Mo/Al/Mo. The first bottom conductive layer 1100 may have a three-layered structure of Ti/Al/Ti. However, the present disclosure is not limited thereto, and a layered structure of the first bottom conductive layer 1100 and a material thereof may be variously modified as needed or desired.

The first bottom conductive layer 1100 may include a common voltage auxiliary line 1110 extending in a first direction (e.g., the x axis direction), a power voltage auxiliary line 1120 also extending in the first direction, and a first capacitor electrode 1130.

As described above, because the common voltage line arranged outside the display area DA may have a loop shape having one open side, the common voltage line may have a shape partially surrounding (e.g., around a periphery of) the display area DA. Because the common voltage auxiliary line 1110 extending in the first direction electrically connects one side of the common voltage line to another side (e.g., an opposite side) of the common voltage line, the constant second power voltage ELVSS (e.g., the common voltage) may be applied to the common electrode, which may be commonly formed over the entire or substantially the entire display area DA.

The power voltage auxiliary line 1120 extending in the first direction may be electrically connected to a power line 1520 (e.g., see FIG. 9) extending in a second direction (e.g., the y axis direction). Because the power voltage auxiliary lines 1120 and the power lines 1520 may be electrically connected to each other to form a conductive layer of a mesh structure in the display area DA, the constant first power voltage ELVDD (e.g., the driving voltage) may be maintained over the display area DA entirely.

The first capacitor electrode 1130 may have an isolated shape. The first capacitor electrode 1130 may serve as one electrode of the first capacitor C1, and at the same time, may serve as one electrode of the second capacitor C2. The first capacitor electrode 1130 may be electrically connected to the gate electrode and the second terminal of the first transistor T1, the first terminal of the fourth transistor T4, the pixel electrode of the organic light-emitting diode OLED, and the like by a first connection electrode 1541 (e.g., see FIG. 9) described in more detail below. The first capacitor electrode 1130 may include a first part 1131 and a second part 1132 connected to each other as shown in FIG. 5. The first part 1131 may serve as one electrode of the second capacitor C2, and the second part 1132 may serve as one electrode of the first capacitor C1. This is described in more detail below.

A second buffer layer 112 may be disposed over the substrate 100 to cover the first bottom conductive layer 1100. The second buffer layer 112 may include an insulating material. As an example, the second buffer layer 112 may include an inorganic insulating layer, such as silicon oxide, silicon nitride, silicon oxynitride, or aluminum oxide.

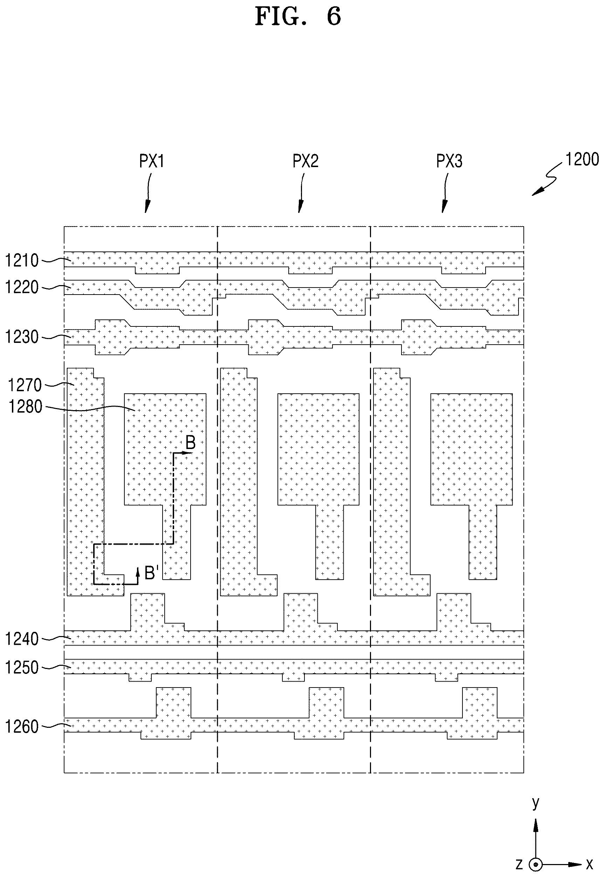

A second bottom conductive layer 1200 shown in FIG. 6 may be disposed on the second buffer layer 112. The second bottom conductive layer 1200 may include a metal, an alloy, a conductive metal oxide, a transparent conductive material, and/or the like. As an example, the second bottom conductive layer 1200 may include silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. The second bottom conductive layer 1200 may have a multi-layered structure. As an example, the second bottom conductive layer 1200 may have a two-layered structure of Mo/Al, or a three-layered structure of Mo/Al/Mo. The second bottom conductive layer 1200 may have a three-layered structure of Ti/Al/Ti. However, the present disclosure is not limited thereto, and a layered structure of the second bottom conductive layer 1200 and a material thereof may be variously modified as needed or desired.

The second bottom conductive layer 1200 may include a reference voltage auxiliary line 1210 (e.g., see VRL in FIG. 2) extending in the first direction (e.g., the x axis direction), a third scan line 1220 (e.g., see GRL in FIG. 2), a first scan line 1230 (e.g., see GWL in FIG. 2), an emission control line 1240 (e.g., see EL in FIG. 2), an initialization voltage line 1250 (e.g., see VIL in FIG. 2), and the second scan line 1260 (e.g., see GIL in FIG. 2). The function of the reference voltage auxiliary line 1210 is described in more detail below. Functions of the other lines have been described above with reference to FIGS. 2 and 3, and thus, redundant description thereof may not be repeated.

In addition to the above-described lines, the second bottom conductive layer 1200 may include a second capacitor electrode 1270 having an isolated shape, and a third capacitor electrode 1280 having an isolated shape. In other words, the third capacitor electrode 1280 may be arranged at (e.g., in or on) the same layer as that of the second capacitor electrode 1270 to be spaced apart from the second capacitor electrode 1270. The second capacitor electrode 1270 may be disposed over the first capacitor electrode 1130 to overlap with the first capacitor electrode 1130. In other words, the second capacitor electrode 1270 may include a portion overlapping with the first capacitor electrode 1130. In more detail, the second capacitor electrode 1270 may include a portion overlapping with the first part 1131 of the first capacitor electrode 1130. The first part 1131 of the first capacitor electrode 1130 and the second capacitor electrode 1270 may form the second capacitor C2 (e.g., see FIG. 2). The third capacitor electrode 1280 may be disposed over the first capacitor electrode 1130 to also overlap with the first capacitor electrode 1130. In other words, the third capacitor electrode 1280 may include a portion overlapping with the first capacitor electrode 1130. In more detail, the third capacitor electrode 1280 may include a portion overlapping with the second part 1132 of the first capacitor electrode 1130. The second part 1132 of the first capacitor electrode 1130 and the third capacitor electrode 1280 may form the first capacitor C1 (e.g., see FIG. 2).

A third buffer layer 113 may be disposed over the substrate 100 to cover the second bottom conductive layer 1200. The third buffer layer 113 may include an insulating material. As an example, the third buffer layer 113 may include an inorganic insulating layer, such as silicon oxide, silicon nitride, silicon oxynitride, or aluminum oxide.

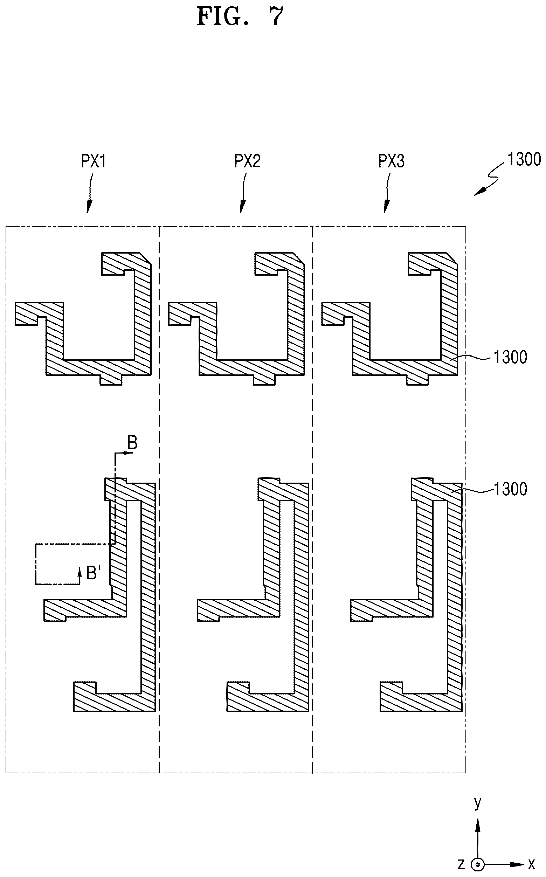

As shown in FIG. 7, a semiconductor layer 1300 may be disposed on the third buffer layer 113. The semiconductor layer 1300 may include an oxide semiconductor as described above. As an example, the semiconductor layer 1300 may include a Zn oxide-based material, such as Zn oxide, In-Zn oxide, and/or Ga-In-Zn oxide. As another example, the semiconductor layer 1300 may include In-Ga-Zn-O (IGZO), In-Sn-Zn-O (ITZO), or In-Ga-Sn-Zn-O (IGTZO) containing a metal, such as indium (In), gallium (Ga), and/or stannum (Sn) in zinc oxide (ZnOₓ), such as ZnO or ZnO₂.

The first to fifth transistors T1, T2, T3, T4, and T5 are disposed along the semiconductor layer 1300. FIG. 7 shows that the semiconductor layer 1300 includes two portions that are spaced apart from each other. These two portions may be electrically connected to elements included in a source/drain layer 1500 described in more detail below.

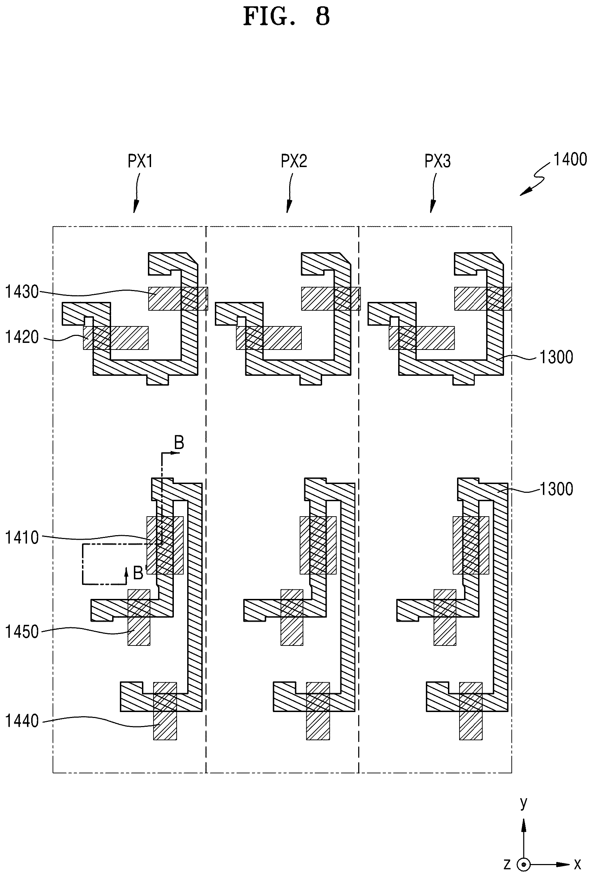

A gate insulating layer 115 may be disposed on the semiconductor layer 1300. Although the gate insulating layer 115 may be disposed over the substrate 100 to cover the semiconductor layer 1300, the gate insulating layer 115 may be patterned to have the same or substantially the same shape as that of a gate layer 1400 (e.g., see FIG. 8) disposed on the gate insulating layer 115 as shown in FIG. 10. The gate insulating layer 115 may include an insulating material. As an example, the gate insulating layer 115 may include an inorganic insulating layer, such as silicon oxide, silicon nitride, silicon oxynitride, or aluminum oxide.

As shown in FIG. 8, the gate layer 1400 may be disposed on the gate insulating layer 115. For convenience of illustration, FIG. 8 shows the gate layer 1400 together with the semiconductor layer 1300 disposed thereunder. The gate layer 1400 may include a first gate electrode 1410, a second gate electrode 1420, a third gate electrode 1430, a fourth gate electrode 1440, and a fifth gate electrode 1450, and the gate electrodes may be arranged to be spaced apart from each other. During the manufacturing process, when forming the first gate electrode 1410 to the fifth gate electrode 1450 that are spaced apart from each other as described above, a conductive layer for forming the gate layer 1400 may be concurrently or substantially simultaneously patterned into the same or substantially the same shape as that of an insulating layer for forming the gate insulating layer 115 therebelow. Accordingly, each of the first gate electrode 1410 to the fifth gate electrode 1450 may have an isolated shape, and may be disposed on the gate insulating layer 115 having an isolated shape.

The gate layer 1400 may include a metal, an alloy, a conductive metal oxide, a transparent conductive material, and/or the like. As an example, the gate layer 1400 may include silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. The gate layer 1400 may have a multi-layered structure. As an example, the gate layer 1400 may have a two-layered structure of Mo/Al, or a three-layered structure of Mo/Al/Mo.

The first gate electrode 1410 may be a gate electrode of the first transistor T1, which may be a driving transistor. The second gate electrode 1420 may be a gate electrode of the second transistor T2, which may be a data-write transistor. The third gate electrode 1430 may be a gate electrode of the third transistor T3, which may be a first initialization transistor. The fourth gate electrode 1440 may be a gate electrode of the fourth transistor T4, which may be a second initialization transistor. The fifth gate electrode 1450 may be a gate electrode of the fifth transistor T5, which may be an emission control transistor.

For reference, because the first to fifth transistors T1, T2, T3, T4, and T5 may be double-gate transistors as described above, the first to fifth transistors T1, T2, T3, T4, and T5 may further include gate electrodes corresponding to the first gate electrode 1410 to the fifth gate electrode 1450. As an example, the first transistor T1, which may be the driving transistor, may include the first gate electrode 1410 and another gate electrode. The first gate electrode 1410 is electrically connected to the semiconductor layer 1300 by the first connection electrode 1541 described in more detail below, and the other gate electrode may be a portion of the third capacitor electrode 1280 included in the second bottom conductive layer 1200 that overlaps with the first gate electrode 1410. The second transistor T2, which may be the data-write transistor, may include the second gate electrode 1420 and another gate electrode. The second gate electrode 1420 is connected to the first scan line 1230 by a second connection electrode 1542 described in more detail below, and the other gate electrode may be a portion of the first scan line 1230 included in the second bottom conductive layer 1200 that overlaps with the second gate electrode 1420. Like the second transistor T2, each of the third to fifth transistors T3, T4, and T5 may also include two gate electrodes.

It may be understood that the positions of the first gate electrode 1410 to the fifth gate electrode 1450 correspond to the positions of the first to fifth transistors T1, T2, T3, T4, and T5. In addition, portions in which the first gate electrode 1410 to the fifth gate electrode 1450 overlap with the semiconductor layer 1300 may be channel regions of the transistors T1, T2, T3, T4, and T5. In the semiconductor layer 1300, one side and another side (e.g., an opposite side) of each of the channel regions may be a first terminal and a second terminal of a corresponding thin-film transistor.

An interlayer insulating layer 117 may be disposed over the substrate 100 to cover the gate layer 1400. As shown in FIG. 10, in the case where the gate insulating layer 115 is patterned to correspond to the elements of the gate layer 1400, the interlayer insulating layer 117 may be disposed on the third buffer layer 113 to cover the gate layer 1400. The interlayer insulating layer 117 may include an insulating material. As an example, the interlayer insulating layer 117 may include silicon oxide, silicon nitride, silicon oxynitride, or aluminum oxide.

The source/drain layer 1500 shown in FIG. 9 may be disposed on the interlayer insulating layer 117.

The source/drain layer 1500 may include the data line 1510 (e.g., see DL in FIG. 2), the power line 1520 (e.g., see PL in FIG. 2), and a reference voltage line 1530 (e.g., see VRL in FIG. 2) extending in the second direction (e.g., the y axis direction) or approximately in the second direction. In addition, the source/drain layer 1500 may include connection electrodes of an isolated shape. FIG. 9 shows that the source/drain layer 1500 includes the first connection electrode 1541, the second connection electrode 1542, a third connection electrode 1543, a fourth connection electrode 1544, a fifth connection electrode 1545, a sixth connection electrode 1546, and a seventh connection electrode 1547.

The source/drain layer 1500 may include a metal, an alloy, a conductive metal oxide, a transparent conductive material, and/or the like. As an example, the source/drain layer 1500 may include silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. The source/drain layer 1500 may have a multi-layered structure. As an example, the source/drain layer 1500 may have a two-layered structure of Ti/Al, or a three-layered structure of Ti/Al/Ti.

Because the data line 1510 is electrically connected to the semiconductor layer 1300 therebelow through a contact hole 1510CNT, a data signal DATA from the data line 1510 may be transferred to the semiconductor layer 1300 and applied to the first terminal of the second transistor T2.

The power line 1520 is electrically connected to the power voltage auxiliary line 1120 therebelow through a contact hole 1520CNT1. Because the power voltage auxiliary line 1120 extends in the first or approximately in the first direction (e.g., the x axis direction) and the power line 1520 extends in the second or approximately in the second direction (e.g., the y axis direction), these lines may be electrically connected to each other form a conductive layer of a mesh structure in the display area DA, and thus, the constant first power voltage ELVDD (e.g., the driving voltage) may be maintained over the display area DA entirely.

The power line 1520 is electrically connected to the semiconductor layer 1300 therebelow through a contact hole 1520CNT2. As such, the first power voltage ELVDD (e.g., the driving voltage) may be transferred to the semiconductor layer 1300 and applied to the first terminal of the fifth transistor T5. In addition, the power line 1520 is electrically connected to the second capacitor electrode 1270 of the second bottom conductive layer 1200 therebelow through a contact hole 1520CNT3. As such, the first power voltage ELVDD (e.g., the driving voltage) may be applied to the second capacitor electrode 1270 of the second capacitor C2.

The reference voltage line 1530 is electrically connected to the reference voltage auxiliary line 1210 of the second bottom conductive layer 1200 through a contact hole 1530CNT1. Because the reference voltage auxiliary line 1210 extends in the first or approximately in the first direction (e.g., the x axis direction), and the reference voltage line 1530 extends in the second or approximately in the second direction (e.g., the y axis direction), these lines may be electrically connected to each other form a conductive layer of a mesh structure in the display area DA, and thus, the constant reference voltage VREF may be maintained over the display area DA entirely. In addition, the reference voltage line 1530 is electrically connected to the semiconductor layer 1300 therebelow through a contact hole 1530CNT2. As such, the reference voltage VREF may be transferred to the semiconductor layer 1300 and applied to the first terminal of the third transistor T3.

The first connection electrode 1541 is electrically connected to the first capacitor electrode 1130 of the first bottom conductive layer 1100 therebelow through a contact hole 1541CNT1. In addition, the first connection electrode 1541 is electrically connected to the first gate electrode 1410 of the first transistor T1 therebelow through a contact hole 1541CNT2. In addition, the first connection electrode 1541 is electrically connected to the semiconductor layer 1300 therebelow, such as to the second terminal of the first transistor T1, through a contact hole 1541CNT3. As described above, the first connection electrode 1541 may serve to form the third node N3 as illustrated in FIG. 2.

The first connection electrode 1541 is connected to a pixel electrode 210 thereabove through a contact hole 211CNT formed in a planarization layer 119 described in more detail below and disposed thereabove. Accordingly, the driving current I_{d} or the initialization voltage VINT from the semiconductor layer 1300 may be transferred to the pixel electrode 210 of the organic light-emitting diode OLED through the first connection electrode 1541.

The second connection electrode 1542 is electrically connected to the first scan line 1230 therebelow through a contact hole 1542CNT1, and is also electrically connected to the second gate electrode 1420 through a contact hole 1542CNT2. Accordingly, the second connection electrode 1542 allows a scan signal from the first scan line 1230 to be applied to the second gate electrode 1420 of the second transistor T2, which may be the data-write transistor.

The third connection electrode 1543 is electrically connected to the third scan line 1220 therebelow through a contact hole 1543CNT1, and also electrically connected to the third gate electrode 1430 through a contact hole 1543CNT2. Accordingly, the third connection electrode 1543 allows a scan signal from the third scan line 1220 to be applied to the third gate electrode 1430 of the third transistor T3, which may be the first initialization transistor.

The fourth connection electrode 1544 is electrically connected to the second scan line 1260 therebelow through a contact hole 1544CNT1, and also electrically connected to the fourth gate electrode 1440 through a contact hole 1544CNT2. Accordingly, the fourth connection electrode 1544 allows a scan signal from the second scan line 1260 to be applied to the fourth gate electrode 1440 of the fourth transistor T4, which may be the second initialization transistor.

The fifth connection electrode 1545 is electrically connected to the emission control line 1240 therebelow through a contact hole 1545CNT1, and also electrically connected to the fifth gate electrode 1450 through a contact hole 1545CNT2. Accordingly, the fifth connection electrode 1545 allows an emission control signal from the emission control line 1240 to be applied to the fifth gate electrode 1450 of the fifth transistor T5, which may be the emission control transistor.

The sixth connection electrode 1546 is electrically connected to the third capacitor electrode 1280 therebelow through a contact hole 1546CNT1, and also electrically connected to the semiconductor layer 1300 through a contact hole 1546CNT2. Accordingly, the sixth connection electrode 1546 electrically connects the third capacitor electrode 1280 of the first capacitor C1 to the second terminal of the second transistor T2, which may be the data-write transistor, and the second terminal of the third transistor T3, which may be the first initialization transistor. As described above, the sixth connection electrode 1546 may serve to form the first node N1 as illustrated in FIG. 2.

The seventh connection electrode 1547 is electrically connected to the initialization voltage line 1250 therebelow through a contact hole 1547CNT1, and also electrically connected to the semiconductor layer 1300 through a contact hole 1547CNT2. Accordingly, the seventh connection electrode 1547 allows the initialization voltage VINT from the initialization voltage line 1250 to be applied to the fourth transistor T4, which may be the second initialization transistor.

The planarization layer 119 may cover the source/drain layer 1500, and may be disposed on the interlayer insulating layer 117. The planarization layer 119 may include an organic insulating material. As an example, the planarization layer 119 may include benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a suitable mixture thereof.

The organic light-emitting diode OLED may be disposed on the planarization layer 119. The organic light-emitting diode OLED may include the pixel electrode 210, an intermediate layer 220, and the common electrode 230. The intermediate layer 220 may include an emission layer.

The pixel electrode 210 may be a (semi) light-transmissive electrode or a reflective electrode. As an example, the pixel electrode 210 may include a reflective layer, and a transparent or semi-transparent electrode layer on the reflective layer. The reflective layer may include Ag, Mg, Al, Pt, Pd, Au, Ni, Nd, Ir, Cr, or a suitable compound thereof. The transparent or semi-transparent electrode layer may include at least one of indium tin oxide (ITO), indium zinc oxide (IZO), zinc oxide (ZnOₓ: ZnO or ZnO₂), indium oxide (In₂O₃), indium gallium oxide (IGO), or aluminum zinc oxide (AZO). As an example, the pixel electrode 210 may have a three-layered structure of ITO/Ag/ITO.

A pixel-defining layer 121 may be disposed on the planarization layer 119. The pixel-defining layer 121 may prevent or substantially prevent arcs and the like from occurring at the edges of each pixel electrode 210, by increasing a distance between the edges of each pixel electrode 210 and the common electrode 230 over the pixel electrode 210. In other words, the pixel-defining layer 121 may expose a central portion of the pixel electrode 210 by including an opening. The pixel-defining layer 121 may include an organic insulating material, such as polyimide, an acrylic resin, benzocyclobutene, a phenolic resin, and/or the like, and may be formed by using spin coating and/or the like.

At least a portion of the intermediate layer 220 including the emission layer of the organic light-emitting diode OLED may be disposed in the opening formed in the pixel-defining layer 121. A light-emitting area of an organic light-emitting diode OLED may be defined by the opening. The intermediate layer 220 may include the emission layer. The emission layer may include an organic material including a fluorescent or phosphorous material configured to emit red, green, blue, or white light. The emission layer may include a polymer organic material or a low molecular weight organic material. Functional layers may be selectively further arranged under and/or above the emission layer. The functional layers may include a hole transport layer (HTL), a hole injection layer (HIL), an electron transport layer (ETL), and/or an electron injection layer (EIL).

The emission layer may have a shape patterned to correspond to each of the pixel electrodes 210. Layers of the intermediate layer other than the emission layer may be integrated (e.g., may each be integrally formed) throughout the plurality of pixel electrodes 210. However, the present disclosure is not limited thereto, and various modifications may be made.

The common electrode 230 may be a light-transmissive electrode or a reflective electrode. As an example, the common electrode 230 may be a transparent or semi-transparent electrode, and may include a metal thin film including Li, Ca, Al, Ag, Mg, or a suitable compound thereof (e.g., LiF) having a small work function. In addition, the common electrode 230 may further include a transparent conductive oxide (TCO) layer, such as ITO, indium zinc oxide (IZO), ZnO, ZnO₂, or In₂O₃ disposed on the metal thin film. The common electrode 230 may be integrally formed over the entire or substantially the entire surface of the display area DA to cover the display area DA, and may be disposed on the intermediate layer 220 and the pixel-defining layer 121.

In the display apparatus according to an embodiment, the first capacitor C1 may be formed by the second part 1132 of the first capacitor electrode 1130 and the third capacitor electrode 1280 disposed thereover, and the second capacitor C2 may be formed by the first part 1131 of the first capacitor electrode 1130 and the second capacitor electrode 1270 disposed thereover. In this case, the second buffer layer 112, which may be an inorganic insulating layer, may be disposed between the second part 1132 of the first capacitor electrode 1130 and the third capacitor electrode 1280, and between the first part 1131 of the first capacitor electrode 1130 and the second capacitor electrode 1270. The inorganic insulating layer may include silicon oxide, silicon nitride, silicon oxynitride, or aluminum oxide.

The inorganic insulating layer may be thinner than an organic insulating layer, and may have a relatively high dielectric constant. Accordingly, a capacitance of each of the first capacitor C1 and the second capacitor C2 may be increased (e.g., may be remarkably increased). In the case where a high-resolution display apparatus is implemented, the area of each of capacitors may be inevitably reduced in a plan view. On the other hand, in the display apparatus according to an embodiment, through the above-described configuration, even when a high-resolution display apparatus is implemented, capacitances of the first capacitor C1 and the second capacitor C2 may be sufficiently increased.

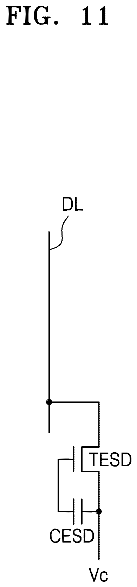

FIG. 11 is a circuit diagram of an electrostatic discharge protective circuit included in the display apparatus of FIG. 1.

Referring to FIG. 11, to discharge static electricity flowing into the data lines DL, the electrostatic discharge protective circuit may be electrically connected to each of the data lines DL. The electrostatic discharge protective circuit may be arranged in the peripheral area PA outside the display area DA. In more detail, as described above, because the printed circuit board 30 and the like may be attached to an end of the sub-region SR of the display panel 10, and the printed circuit board 30 and the like may be electrically connected to the driving chip 20 and the like through a plurality of pads arranged along one edge of the substrate, the electrostatic discharge protective circuit may be arranged between the display area DA and the pads.

One end of the electrostatic discharge protective circuit is electrically connected to the data line DL, and another end thereof may be electrically connected to a constant voltage source to which a constant voltage Vc is applied. The constant voltage source may be the power supply line maintained at the first power voltage ELVDD (e.g., the driving voltage), or the common voltage line maintained at the second power voltage ELVSS (e.g., the common voltage), as described in more detail below.

The electrostatic discharge protective circuit may include a protective transistor TESD and a protective capacitor CESD. The protective capacitor CESD may be arranged between a protective gate electrode of the protective transistor TESD and the constant voltage source. The protective transistor TESD maintains a turn-off state when a normal data signal is applied to the data line DL, and when a high voltage greater than a voltage corresponding to the normal data signal is applied to the data line DL, the protective transistor TESD is turned on to allow a current to flow from the data line DL to the constant voltage source. As needed or desired, an additional protective capacitor may be arranged between the protective gate electrode of the protective transistor TESD and the data line DL. However, the present disclosure is not limited thereto, and various modifications may be made.

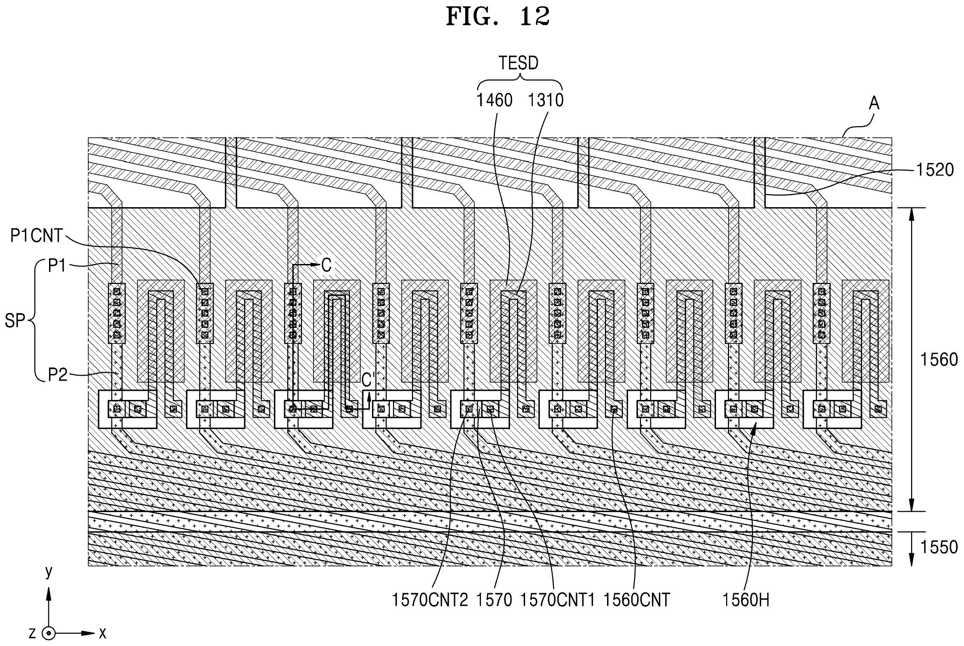

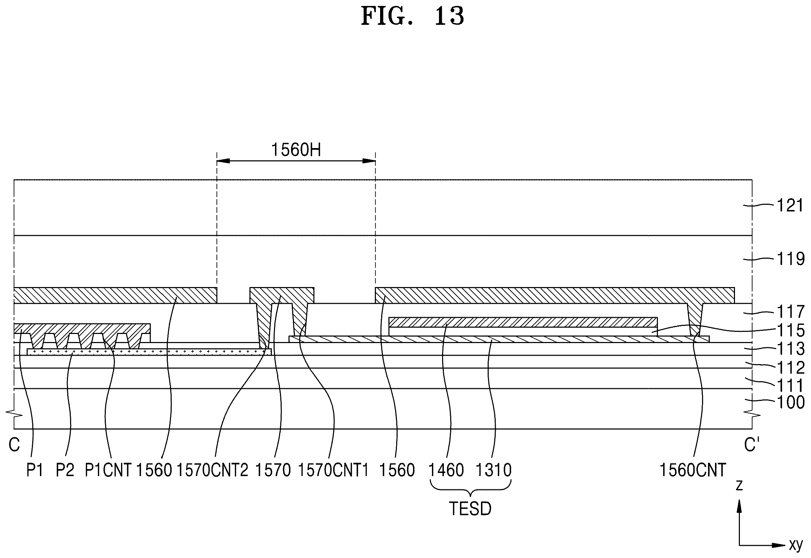

FIG. 12 is a schematic layout view of the region A of FIG. 1. FIG. 12 may show a plurality of electrostatic discharge protective circuits. FIG. 13 is a schematic cross-sectional view of the display apparatus taken along the line C-C' of FIG. 12. As described in more detail below, each of the plurality of electrostatic discharge protective circuits may be electrically connected to a corresponding data line DL from among the data lines DL.

Referring to FIG. 12, a plurality of spider lines SP may be arranged in the peripheral area PA. Each of the plurality of spider lines SP may be electrically connected to the driving chip 20 (e.g., see FIG. 1), and also, may be electrically connected to a corresponding data line DL from among the data lines DL. In other words, each of the plurality of spider lines SP may be configured to transfer a data signal from the driving chip 20 to a corresponding one from among the data lines DL. Each of the plurality of electrostatic discharge protective circuits may be electrically connected to a corresponding one from among the plurality of spider lines SP as shown in FIGS. 12 and 13, and thus, may be electrically connected to a corresponding one from among the data lines DL as shown in FIG. 11.

Each of the plurality of electrostatic discharge protective circuits may include the protective transistor TESD and the protective capacitor CESD, as described above.

Referring to FIGS. 12 and 13, a protective semiconductor layer 1310 of the protective transistor TESD may include the same material as that of the semiconductor layer 1300 shown in FIG. 7, and may be concurrently or substantially simultaneously formed with the semiconductor layer 1300. In other words, the protective semiconductor layer 1310 may be disposed on the third buffer layer 113. A protective gate electrode 1460 of the protective transistor TESD may be disposed on the protective semiconductor layer 1310 to have a portion overlapping with the protective semiconductor layer 1310. The gate insulating layer 115 may be disposed between the protective gate electrode 1460 and the protective semiconductor layer 1310. Although the gate insulating layer 115 may be disposed over the third buffer layer 113 to cover the protective semiconductor layer 1310, the gate insulating layer 115 may be patterned to have the same or substantially the same shape as that of the protective gate electrode 1460 disposed on the gate insulating layer 115 as shown in FIG. 13. The protective gate electrode 1460 may include the same material as that of the gate layer 1400, and may be concurrently or substantially simultaneously formed with the gate layer 1400 as shown in FIG. 8.

A power supply line 1560 may be disposed over the protective transistor TESD. The power supply line 1560 may have a shape extending in the first direction (e.g., the x axis direction) to be arranged between the display area DA and the driving chip 20. The power supply line 1560 may be disposed on the interlayer insulating layer 117. Accordingly, the power supply line 1560 may include the same material as that of the source/drain layer 1500, and may be formed concurrently or substantially simultaneously with the source/drain layer 1500 as shown in FIG. 9. The power line PL (e.g., 1520) may be electrically connected to the power supply line 1560, and the power line PL may extend in the second direction (e.g., the y axis direction) to extend into the display area DA. FIG. 12 shows that the power supply line 1560 and the power line PL (e.g., 1520) are integrated with each other. The power supply line 1560 receives the first power voltage ELVDD (e.g., the driving voltage) from the driving chip 20 and the like, and transfers the same to the power line PL (e.g., 1520) to allow the first power voltage ELVDD to be applied to the pixels in the display area DA.

For reference, FIG. 12 shows that a common voltage line 1550 that is electrically connected to the common electrode 230 is arranged between the power supply line 1560 and the driving chip 20 (e.g., see FIG. 1). As described above, because the power supply line 1560 arranged in the peripheral area PA has a loop shape in which a portion thereof between the display area DA and the driving chip 20 (e.g., see FIG. 1) is open, the power supply line 1560 may have a shape partially surrounding (e.g., around a periphery of) the display area DA. In this case, at least a portion of the power supply line 1560 may be arranged to correspond to a portion of the display area DA in a direction (e.g., the -y axis direction) to the driving chip 20. As shown in FIG. 1, the region A is a portion closer to one side (e.g., in the -x axis direction) from the center of the display area DA, and thus, there may be the common voltage line 1550 in the relevant portion as illustrated in FIG. 12 showing the region A of FIG. 1. This is also applicable to the embodiments described in more detail below and modifications thereof.

The power supply line 1560 has a portion overlapping with the protective gate electrode 1460 of the protective transistor TESD. Accordingly, the power supply line 1560 and the protective gate electrode 1460 may form the protective capacitor CESD shown in FIG. 11.

Each of the spider lines SP may include a first portion P1 and a second portion P2 as shown in FIGS. 12 and 13. The power supply line 1560 extending in the first direction (e.g., the x axis direction) as described above may be disposed over the spider lines SP.

The second portion P2 may be disposed on the second buffer layer 112. The second portion P2 may include the same material as that of the second bottom conductive layer 1200 shown in FIG. 6, and may be concurrently or substantially simultaneously formed with the second bottom conductive layer 1200. Accordingly, the third buffer layer 113 may cover the second portion P2. The second portion P2 may extend toward the driving chip 20 (e.g., see FIG. 1), and may be electrically connected to the driving chip 20 and the like.

The first portion P1 may be disposed over the third buffer layer 113 covering the second portion P2, and may have a portion overlapping with the second portion P2. The gate insulating layer 115 may be disposed between the first portion P1 and the third buffer layer 113. As needed or desired, the gate insulating layer 115 may be patterned to have the same or substantially the same edge shape as that of the first portion P1 disposed on the gate insulating layer 115 as shown in FIG. 13. The first portion P1 may include the same material as that of the protective gate electrode 1460 and the gate layer 1400, and may be concurrently or substantially simultaneously formed with the protective gate electrode 1460 and the gate layer 1400 as shown in FIG. 8. The first portion P1 may be electrically connected to the second portion P2 through a contact hole P1CNT formed in the gate insulating layer 115. FIGS. 12 and 13 show that the first portion P1 is connected to the second portion P2 through five contact holes P1CNT, but the present disclosure is not limited thereto. The first portion P1 may extend in a direction to the display area DA, and may be electrically connected to the data line DL (e.g., 1510) corresponding thereto.

The protective transistor TESD of each of the protective circuits may be electrically connected to a corresponding one from among the spider lines SP, and may also electrically connected to the power supply line 1560. In more detail, one end of the protective semiconductor layer 1310 of the protective transistor TESD may be electrically connected to the power supply line 1560, and another end of the protective semiconductor layer 1310 may be electrically connected to a corresponding one from among the spider lines SP through a bridge line 1570. FIGS. 12 and 13 show that the power supply line 1560 is in contact with one end of the protective semiconductor layer 1310 through a contact hole 1560CNT formed in the interlayer insulating layer 117. In addition, FIGS. 12 and 13 show that the bridge line 1570 is in contact with the other end of the protective semiconductor layer 1310 through a contact hole 1570CNT1 formed in the interlayer insulating layer 117, and is in contact with the second portion P2 of the spider line SP through a contact hole 1570CNT2 formed in the third buffer layer 113 and the interlayer insulating layer 117. However, the present disclosure is not limited thereto, and by changing a layout, the bridge line 1570 may be in contact with the first portion P1 of the spider line SP instead of the second portion P2. Moreover, various modifications may be made as needed or desired.

The bridge line 1570 may include the same material as that of the power supply line 1560, and may be concurrently or substantially simultaneously formed with the power supply line 1560. Like the power supply line 1560, the bridge line 1570 may be disposed on the interlayer insulating layer 117. As such, as shown in FIG. 12, the power supply line 1560 may include through holes 1560H corresponding to the plurality of protective circuits. When viewed in a direction (e.g., the z axis direction) perpendicular to or substantially perpendicular to the substrate 100 (e.g., in a plan view), the bridge line 1570 may be arranged in (e.g., inside) a corresponding through hole 1560H from among the through holes 1560H.

Because the electrostatic discharge protective circuit is electrically connected to the data line DL, the electrostatic discharge protective circuit may be arranged in a portion in a direction (e.g., the +y axis direction in FIG. 1) opposite to the direction in which the driving chip 20 and the like are arranged with the display area DA therebetween. However, because the corner of the substrate 100 has a rounded shape in a plan view as shown in FIG. 1, there may not be enough space for the electrostatic discharge protective circuits to be arranged in the corresponding portion. Accordingly, because the electrostatic discharge protective circuits are not connected to some of the data lines DL arranged near edges on two opposite sides of the display area DA extending in the second direction (e.g., the y axis direction), there may be data lines DL to which the electrostatic discharge protective circuits are connected and data lines DL to which the electrostatic discharge protective circuits are not connected.

The protective transistor TESD of the electrostatic discharge protective circuit is normally turned off when the voltage of the protective gate electrode is in a floating state, and when static electricity or the like flows into the data line DL from the outside, the protective transistor TESD is turned on. However, in the case where the gate voltage of the protective transistor TESD is maintained or substantially maintained in a floating state for an extend time (e.g., a long time), because the voltage of the protective gate electrode may have a voltage between a data voltage (e.g., 0.5 V to 8 V) applied to the data line DL and the first power voltage ELVDD (e.g., the driving voltage, for example, 8 V to 13 V) applied to the power supply line 1560, a weak leakage current may flow through the protective transistor TESD. In this case, due to the weak leakage current flowing through the electrostatic discharge protective circuit, even though the same electrical signals are applied to all of the data lines DL, the brightness of the pixels connected to the data lines DL that are connected to the electrostatic discharge protective circuits may be different from the brightness of the pixels connected to the data lines DL that are not connected to the electrostatic discharge protective circuits. Accordingly, the display apparatus cannot be implemented to display high-quality images.

In contrast, in the display apparatus according to an embodiment, each of the electrostatic discharge protective circuits is electrically connected to a corresponding one from among the spider lines SP. In other words, the electrostatic discharge protective circuit may be arranged in a portion of the peripheral area PA in a direction (e.g., the -y axis direction, see FIG. 1) from the display area DA, in which the driving chip 20 and the like are arranged. Accordingly, each of the data lines DL may be electrically connected to a corresponding electrostatic discharge protective circuit, and as a result, the display apparatus may be implemented to display high-quality images. This is also applicable to the embodiments described in more detail below and modifications thereof.

Accordingly, the plurality of data lines DL may correspond one-to-one to the plurality of spider lines SP, and the plurality of spider lines SP may correspond one-to-one to the plurality of electrostatic discharge protective circuits. In addition, as shown in FIG. 12, the plurality of electrostatic discharge protective circuits may be arranged between the plurality of spider lines SP. This is also applicable to the embodiments described in more detail below and modifications thereof.

### Mode for the Invention

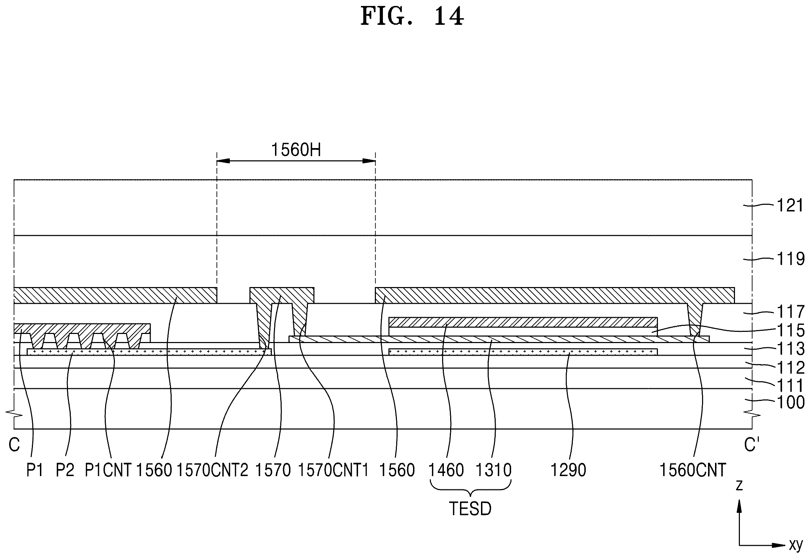

FIG. 14 is a schematic cross-sectional view of a portion of a display apparatus according to an embodiment.

While FIGS. 12 and 13 show that the protective transistor TESD includes one protective gate electrode 1460, the present disclosure is not limited thereto. As an example, referring to FIG. 14, the protective transistor TESD may include two protective gate electrodes. As an example, assuming that the protective gate electrode 1460 described above is a first protective gate electrode 1460, a second protective gate electrode 1290 overlapping with or approximately overlapping with the first protective gate electrode 1460 when viewed in a direction (e.g., the z axis direction) perpendicular to or substantially perpendicular to the substrate 100 (e.g., in a plan view) may be further provided. Like the second portion P2 of the spider line SP, the second protective gate electrode 1290 may be disposed on the second buffer layer 112. In more detail, the second protective gate electrode 1290 may include the same material as that of the second bottom conductive layer 1200 shown in FIG. 6, and may be concurrently or substantially simultaneously formed with the second bottom conductive layer 1200. Accordingly, the third buffer layer 113 may cover the second protective gate electrode 1290.

The second protective gate electrode 1290 may be electrically connected to the first protective gate electrode 1460. As described above with reference to FIGS. 12 and 13, the spider line SP may include the first portion P1 and the second portion P2, and the first portion P1 may be connected to the second portion P2 disposed therebelow through the contact hole P1CNT. The second protective gate electrode 1290 and the second portion P2 are disposed on the second buffer layer 112, and the first protective gate electrode 1460 and the first portion P1 are disposed on the gate insulating layer 115. Accordingly, the second protective gate electrode 1290 and the second portion P2 include the same material as each other and are concurrently or substantially simultaneously formed with each other, the third buffer layer 113 and the like are formed, and then, when forming the contact hole P1CNT for electrically connecting the first portion P1 to the second portion P2, a contact hole for electrically connecting the first protective gate electrode 1460 to the second protective gate electrode 1290 may be concurrently or substantially simultaneously formed. Then, while concurrently or substantially simultaneously forming the first protective gate electrode 1460 and the first portion P1 as each other using the same material, the first protective gate electrode 1460 may be connected to the second protective gate electrode 1290 through the contact hole, and the first portion P1 may be connected to the second portion P2 through the contact hole P1CNT. For reference, the contact hole for electrically connecting the first protective gate electrode 1460 to the second protective gate electrode 1290 may be arranged outside the protective semiconductor layer 1310 in a plan view.

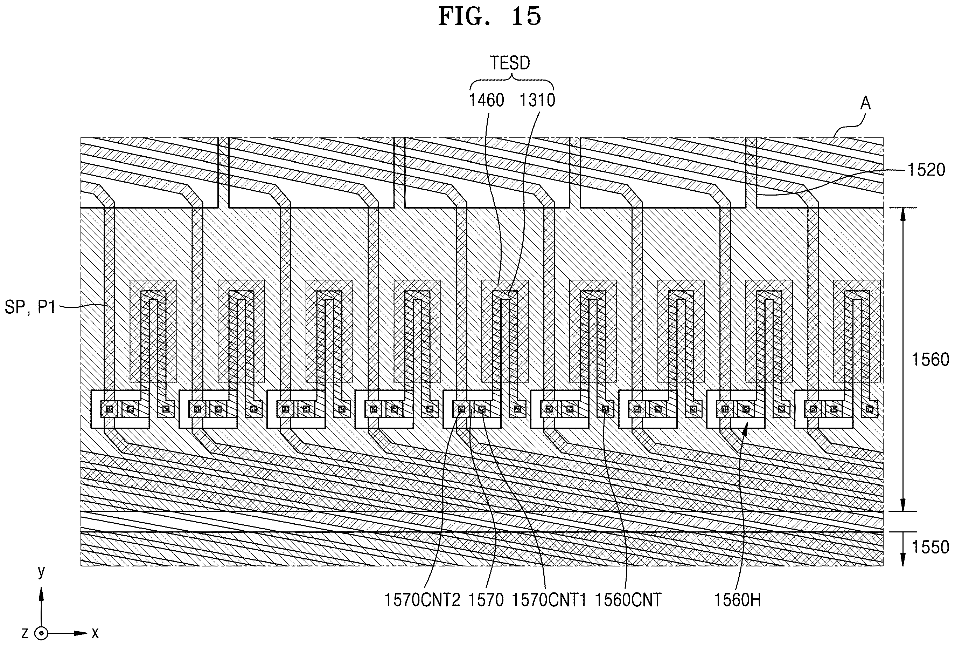

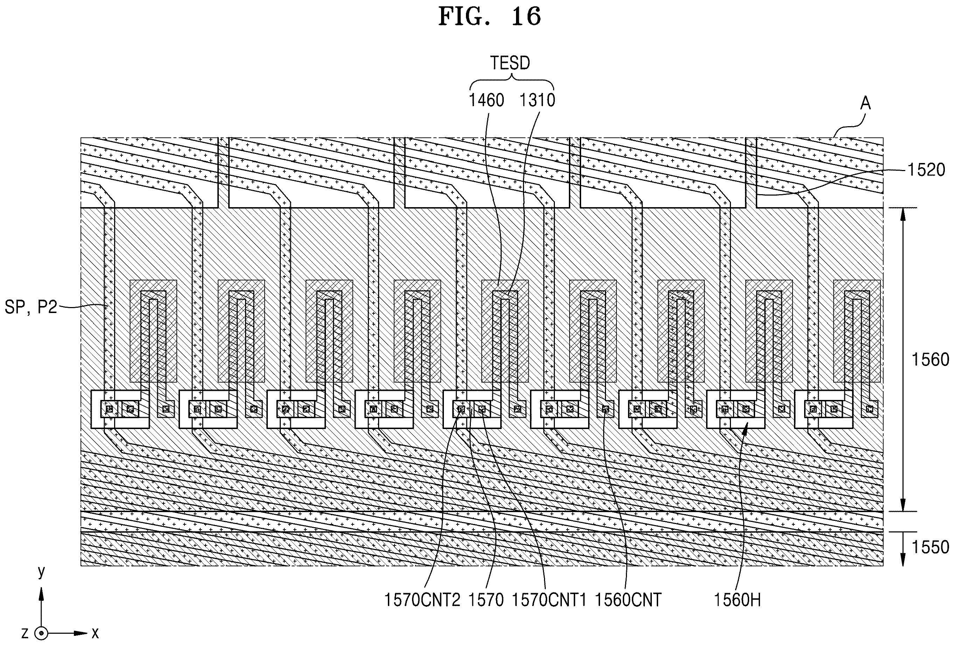

While the spider lines SP including the first portion P1 and the second portion P2 disposed at (e.g., in or on) different layers from each other have been described above, the present disclosure is not limited thereto, for example, as described below with reference to FIGS. 15 and 16.

FIG. 15 is a schematic layout view of a portion of a display apparatus according to an embodiment. FIG. 16 is a schematic layout view of a portion of a display apparatus according to an embodiment.

Referring to FIG. 15, in some embodiments, each of the plurality of spider lines SP may include a portion (e.g., only a portion) arranged at (e.g., in or on) the same layer as that of the protective gate electrode 1460 of each of the electrostatic discharge protective circuits. In FIG. 15, this is denoted by reference numerals SP and P1. As shown in FIG. 16, in some embodiments, each of the plurality of spider lines SP may include a portion (e.g., only a portion) arranged at (e.g., in or on) the same layer as that of the second bottom conductive layer 1200 disposed between the substrate 100 and the protective gate electrode 1460 of each of the electrostatic discharge protective circuits. In FIG. 16, this is denoted by reference numerals SP and P2.

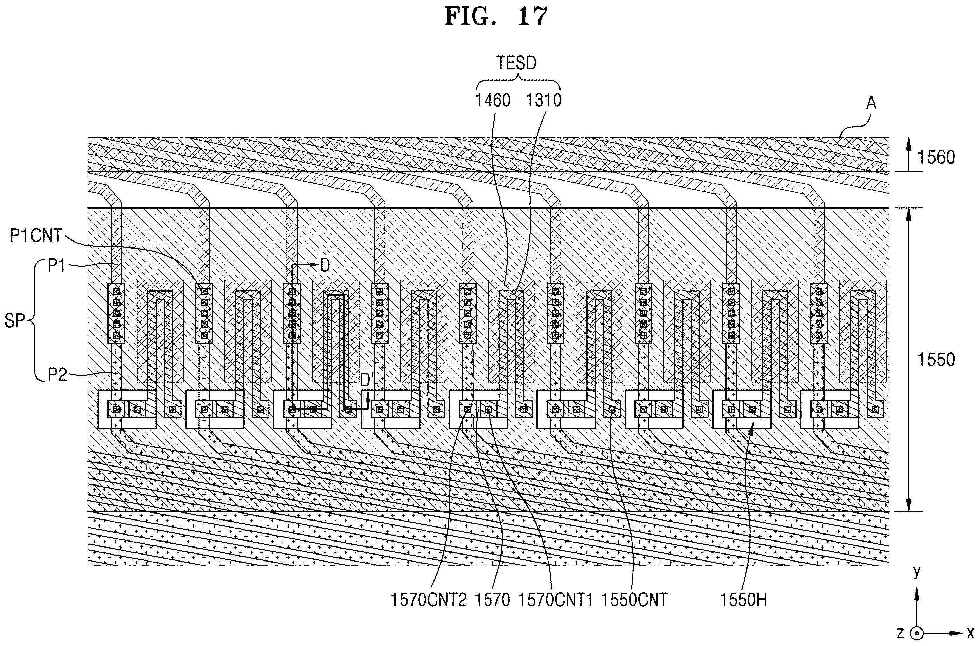

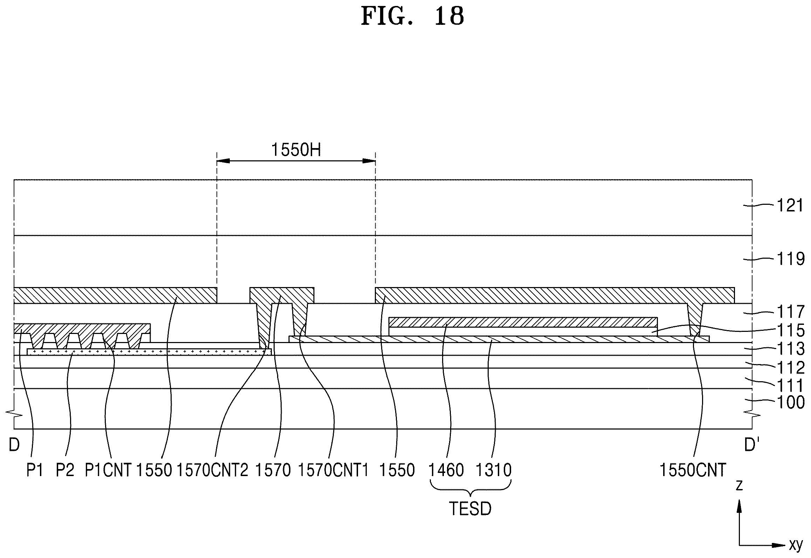

FIG. 17 is a schematic layout view of a portion of a display apparatus according to an embodiment. FIG. 18 is a schematic cross-sectional view of the display apparatus taken along the line D-D' of FIG. 17.

While FIGS. 12 to 16 show that the power supply line 1560 electrically connected to the power lines PL is disposed over the protective transistor TESD, in some embodiments, the common voltage line 1550 may be disposed over the spider lines SP, or in more detail, over the protective transistors TESD in the display apparatus. Accordingly, the power supply line 1560 arranged at (e.g., in or on) the same layer as that of the common voltage line 1550 may be arranged closer to the display area DA.

The protective transistor TESD of each of the protective circuits may be electrically connected to a corresponding one from among the spider lines SP, and may also be electrically connected to the common voltage line 1550. In more detail, one end of the protective semiconductor layer 1310 of the protective transistor TESD may be electrically connected to the common voltage line 1550, and another end of the protective semiconductor layer 1310 may be electrically connected to a corresponding one from among the spider lines SP through a bridge line 1570. FIGS. 17 and 18 show that the common voltage line 1550 is in contact with one end of the protective semiconductor layer 1310 through a contact hole 1550CNT formed in the interlayer insulating layer 117. In addition, FIGS. 17 and 18 show that the bridge line 1570 is in contact with the other end of the protective semiconductor layer 1310 through a contact hole 1570CNT1 formed in the interlayer insulating layer 117, and is in contact with the second portion P2 of the spider line SP through a contact hole 1570CNT2 formed in the third buffer layer 113 and the interlayer insulating layer 117. However, the present disclosure is not limited thereto, and by changing a layout, the bridge line 1570 may be in contact with the first portion P1 of the spider line SP instead of the second portion P2. Thus, various modifications may be made as needed or desired.

The bridge line 1570 may include the same material as that of the common voltage line 1550, and may be concurrently or substantially simultaneously formed with the common voltage line 1550. Like the common voltage line 1550, the bridge line 1570 may be disposed on the interlayer insulating layer 117. As such, as shown in FIG. 17, the common voltage line 1550 may include through holes 1550H corresponding to the plurality of protective circuits, and when viewed in a direction (e.g., the z axis direction) perpendicular to or substantially perpendicular to the substrate 100 (e.g., in a plan view), the bridge line 1570 may be arranged in (e.g., inside) a corresponding through hole 1550H from among the through holes 1550H.

As described above with reference to FIG. 12 and the like, the protective transistor TESD of the electrostatic discharge protective circuit may be electrically connected to the power supply line 1560. Generally, the first power voltage ELVDD (e.g., the driving voltage) applied to the power supply line 1560 may be about 8 V to about 13 V as described above. A data voltage applied to the data line DL may be about 0.5 V to about 8 V. When displaying images of a low grayscale (e.g., a low grayscale value or level), a data voltage close to about 0.5 V may be applied to the data line DL. Accordingly, when the display apparatus displays images of a low grayscale (e.g., a low grayscale value or level) on the whole, a potential difference between the data line DL and the power supply line 1560 may be increased. In this case, when the display apparatus displays images of the low grayscale on the whole, a leakage current may occur through the electrostatic discharge protective circuit from a specific data line DL, and thus, there may be a high probability that the pixels electrically connected to the specific data line DL are recognized by users due to a high potential difference between the specific data line DL and the power supply line 1560.

In contrast, in the display apparatus according to an embodiment, the protective transistor TESD of the electrostatic discharge protective circuit may be electrically connected to the common voltage line 1550. Because the common voltage line 1550 may be grounded or may have an electric potential of about -5 V to about 0 V, when images of a low grayscale (e.g., a low grayscale value or level) on the whole are displayed in the display area DA, a potential difference between the data line DL and the common voltage line 1550 may be relatively small. Accordingly, in the display apparatus according to an embodiment, when the display apparatus displays images of the low grayscale on the whole, even though a leakage current through the electrostatic discharge protective circuit may occur from a specific data line DL, because the potential difference between the specific data line DL and the common voltage line 1550 may not be large, a probability that the pixels electrically connected to the specific data line DL are recognized by users may be reduced (e.g., may be remarkably reduced). Accordingly, the display apparatus according to an embodiment may display high-quality images.

For reference, a case where images of a high grayscale (e.g., a high grayscale value or level) on the whole are displayed in the display area DA may be considered. However, in the case where images of the high grayscale on the whole are displayed in the display area DA, even though a leakage current through the electrostatic discharge protective circuit may occur from a specific data line DL, the pixels electrically connected to the specific data line DL may not be recognized by users. This is because the images of the high grayscale are displayed in the display area DA.

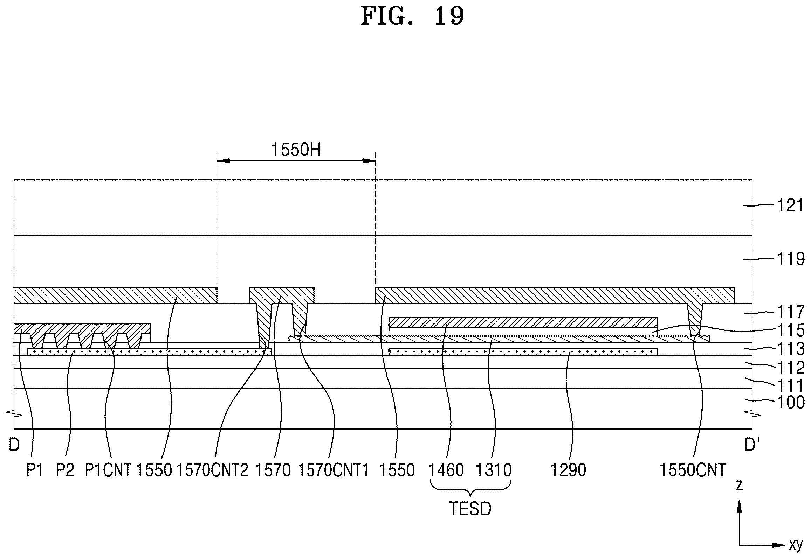

Although FIGS. 17 and 18 show that the protective transistor TESD includes one protective gate electrode 1460, the present disclosure is not limited thereto, for example, as described below with reference to FIG. 19.

FIG. 19 is a schematic cross-sectional view of a portion of a display apparatus according to an embodiment.

Referring to FIG. 19, in some embodiments, the protective transistor TESD may include two protective gate electrodes. As an example, assuming that the protective gate electrode 1460 described above is a first protective gate electrode 1460, a second protective gate electrode 1290 overlapping with or approximately overlapping with the first protective gate electrode 1460 when viewed in a direction (e.g., the z axis direction) perpendicular to or substantially perpendicular to the substrate 100 (e.g., in a plan view) may be further provided. Like the second portion P2 of the spider line SP, the second protective gate electrode 1290 may be disposed on the second buffer layer 112. In more detail, the second protective gate electrode 1290 may include the same material as that of the second bottom conductive layer 1200 shown in FIG. 6, and may be concurrently or substantially simultaneously formed with the second bottom conductive layer 1200. Accordingly, the third buffer layer 113 may cover the second protective gate electrode 1290. The second protective gate electrode 1290 may be electrically connected to the first protective gate electrode 1460, as described above, and thus, redundant description thereof will not be repeated.

As described above with reference to FIGS. 12 and 13, the spider line SP of the display apparatus according to an embodiment as shown in FIGS. 17 and 18 includes the first portion P1 and the second portion P2, and the first portion P1 may be connected to the second portion P2 disposed therebelow through the contact hole P1CNT. The second protective gate electrode 1290 and the second portion P2 are disposed on the second buffer layer 112, and the first protective gate electrode 1460 and the first portion P1 are disposed on the gate insulating layer 115. Accordingly, the second protective gate electrode 1290 and the second portion P2 include the same material as each other and are concurrently or substantially simultaneously formed with each other, the third buffer layer 113 and the like are formed, and then, when forming the contact hole P1CNT for electrically connecting the first portion P1 to the second portion P2, a contact hole for electrically connecting the first protective gate electrode 1460 to the second protective gate electrode 1290 may be concurrently or substantially simultaneously formed. Then, while concurrently or substantially simultaneously forming the first protective gate electrode 1460 and the first portion P1 with each other using the same material, the first protective gate electrode 1460 may be connected to the second protective gate electrode 1290 through the contact hole, and the first portion P1 may be connected to the second portion P2 through the contact hole P1CNT. For reference, the contact hole for electrically connecting the first protective gate electrode 1460 to the second protective gate electrode 1290 may be arranged outside the protective semiconductor layer 1310 in a plan view.

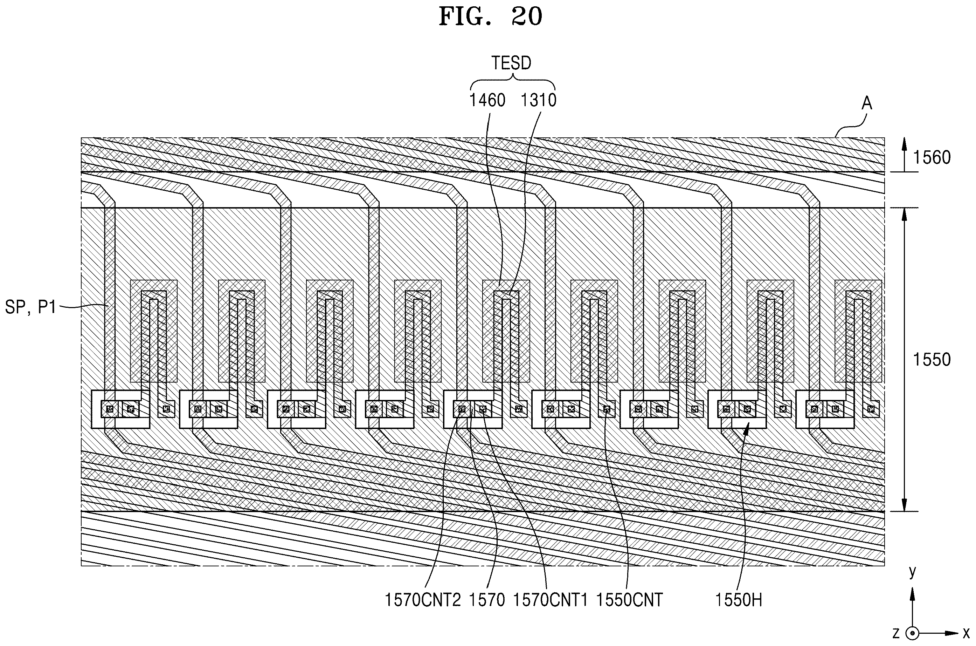

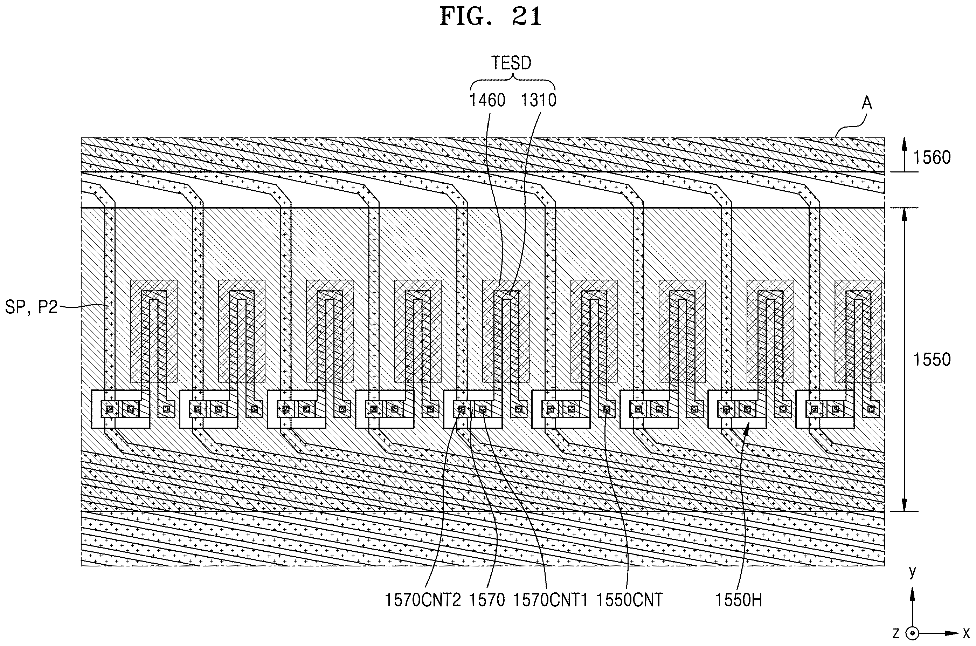

However, the present disclosure is not limited to the case where each of the spider lines SP includes the first portion P1 and the second portion P2 disposed at (e.g., in or on) different layers from each other, for example, as described below with reference to FIGS. 20 and 21.

FIG. 20 is a schematic layout view of a portion of a display apparatus according to an embodiment. FIG. 21 is a schematic layout view of a portion of a display apparatus according to an embodiment.

Referring to FIG. 20, in some embodiments, each of the plurality of spider lines SP may include a portion (e.g., only a portion) arranged at (e.g., in or on) the same layer as that of the protective gate electrode 1460 of each of the electrostatic discharge protective circuits. In FIG. 20, this is denoted by reference numerals SP and P1. In addition, as shown in FIG. 21, in some embodiments, each of the plurality of spider lines SP may include a portion (e.g., only a portion) arranged at (e.g., in or on) the same layer as that of the second bottom conductive layer 1200 disposed between the substrate 100 and the protective gate electrode 1460 of each of the electrostatic discharge protective circuits. In FIG. 21, this is denoted by reference numerals SP and P2.

While the transistors of the pixel and the protective transistor TESD of the electrostatic discharge protective circuit have been described as including the semiconductor layer including an oxide semiconductor, the present disclosure is not limited thereto. In some embodiments, the protective semiconductor layer 1310 of the protective transistor TESD included in the electrostatic discharge protective circuit may include polycrystalline silicon. In this case, at least some of the transistors included in the pixel may include a semiconductor layer including polycrystalline silicon.

According to one or more embodiments of the present disclosure described above, a display apparatus may be implemented that may display high-quality images.

The foregoing is illustrative of some embodiments of the present disclosure, and is not to be construed as limiting thereof. Although some embodiments have been described, those skilled in the art will readily appreciate that various modifications are possible in the embodiments without departing from the spirit and scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the spirit and scope of the present disclosure as defined in the appended claims, and their equivalents.

### Industrial Applicability

The present invention may be applicable to a field of a display apparatus that may display high-quality images.

## Claims

1. A display apparatus comprising:
a substrate including a display area, and a peripheral area outside the display area;
a plurality of data lines crossing the display area;
a plurality of spider lines in the peripheral area, each of the plurality of spider lines being electrically connected to a corresponding data line from among the plurality of data lines; and
a plurality of protective circuits, each of the plurality of protective circuits being electrically connected to a corresponding spider line from among the plurality of spider lines.

2. The display apparatus of claim 1, wherein the plurality of data lines correspond one-to-one to the plurality of spider lines.

3. The display apparatus of claim 2, wherein the plurality of spider lines correspond one-to-one to the plurality of protective circuits.

4. The display apparatus of claim 1, wherein the plurality of protective circuits are located between the plurality of spider lines.

5. The display apparatus of claim 1, further comprising:
a plurality of power lines crossing the display area; and
a power supply line in the peripheral area over the plurality of spider lines, the power supply line being electrically connected to the plurality of power lines.

6. The display apparatus of claim 5, wherein a protective transistor of each of the plurality of protective circuits is electrically connected to the power supply line.

7. The display apparatus of claim 6, wherein one end of a protective semiconductor layer of each of the plurality of protective circuits is electrically connected to the power supply line, and another end of the protective semiconductor layer is electrically connected to the corresponding spider line through a bridge line.

8. The display apparatus of claim 7, wherein the power supply line includes a plurality of through holes corresponding to the plurality of protective circuits, and
wherein, in a plan view, the bridge line is located inside a corresponding through hole from among the plurality of through holes.

9. The display apparatus of claim 8, wherein the bridge line and the power supply line are at the same layer as each other.

10. The display apparatus of claim 8, wherein each of the plurality of spider lines includes a portion located at the same layer as that of a bottom conductive layer, the bottom conductive layer being located between the substrate and a first protective gate electrode of each of the plurality of protective circuits.

11. The display apparatus of claim 8, wherein each of the plurality of spider lines includes a portion located at the same layer as that of a first protective gate electrode of each of the plurality of protective circuits.

12. The display apparatus of claim 8, wherein each of the plurality of spider
lines includes a first portion and a second portion,
wherein the first portion is located at the same layer as that of a first protective gate electrode of each of the plurality of protective circuits, and the second portion is located at the same layer as that of a bottom conductive layer located between the first protective gate electrode and the substrate, and
wherein the first portion is electrically connected to the second portion.

13. The display apparatus of claim 12, wherein each of the plurality of protective circuits includes a second protective gate electrode, and
wherein the second protective gate electrode overlaps with the first protective gate electrode, is located at the same layer as that of the bottom conductive layer, and is electrically connected to the first protective gate electrode.

14. The display apparatus of claim 1, further comprising:
a common electrode covering the display area; and
a common voltage line electrically connected to the common electrode, and located in the peripheral area over the plurality of spider lines.

15. The display apparatus of claim 14, wherein a protective transistor of each of the plurality of protective circuits is electrically connected to the common voltage line.

16. The display apparatus of claim 15, wherein one end of a protective semiconductor layer of each of the plurality of protective circuits is electrically connected to the common voltage line, and another end of the protective semiconductor layer is electrically connected to the corresponding spider line through a bridge line.

17. The display apparatus of claim 16, wherein the common voltage line includes a plurality of through holes corresponding to the plurality of protective circuits, and
wherein, in a plan view, the bridge line is located inside a corresponding through hole from among the plurality of through holes.

18. The display apparatus of claim 17, wherein the bridge line and the common voltage line are located at the same layer as each other.

19. The display apparatus of claim 17, wherein each of the plurality of spider lines includes a portion located at the same layer as that of a bottom conductive layer located between the substrate and a first protective gate electrode of each of the plurality of protective circuits.

20. The display apparatus of claim 17, wherein each of the plurality of spider lines includes a portion located at the same layer as that of a first protective gate electrode of each of the plurality of protective circuits.

21. The display apparatus of claim 17, wherein each of the plurality of spider lines includes a first portion and a second portion,
wherein the first portion is located at the same layer as that of a first protective gate electrode of each of the plurality of protective circuits, and the second portion is located at the same layer as that of a bottom conductive layer located between the first protective gate electrode and the substrate, and
wherein the first portion is electrically connected to the second portion.

22. The display apparatus of claim 21, wherein each of the plurality of protective circuits includes a second protective gate electrode, and
wherein the second protective gate electrode overlaps with the first protective gate electrode, is located at the same layer as that of the bottom conductive layer, and is electrically connected to the first protective gate electrode.

23. A display apparatus comprising:
a substrate including a display area, and a peripheral area outside the display area;
a plurality of pads located along one edge of the substrate in the peripheral area; and
a plurality of protective circuits in the peripheral area between the display area and the plurality of pads.
